(19) Europäisches Patentamt / European Patent Office / Office européen des brevets

(11) **EP 1 875 523 B1**

(12) **EUROPÄISCHE PATENTSCHRIFT**

(45) Veröffentlichungstag und Bekanntmachung des Hinweises auf die Patenterteilung:
**29.09.2010 Patentblatt 2010/39**

(21) Anmeldenummer: **07726466.1**

(22) Anmeldetag: **22.02.2007**

(51) Int Cl.:
**H01L 21/205** $^{(2006.01)}$    **H01L 33/32** $^{(2010.01)}$

(86) Internationale Anmeldenummer:
**PCT/EP2007/051708**

(87) Internationale Veröffentlichungsnummer:
**WO 2007/096405 (30.08.2007 Gazette 2007/35)**

(54) **NITRIDHALBLEITER-BAUELEMENT UND VERFAHREN ZU SEINER HERSTELLUNG**

NITRIDE SEMICONDUCTOR COMPONENT AND METHOD FOR THE PRODUCTION THEREOF

COMPOSANT SEMI-CONDUCTEUR NITRURE ET SON PROCÉDÉ DE FABRICATION

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **23.02.2006 DE 102006008929**
**23.02.2006 US 776457 P**

(43) Veröffentlichungstag der Anmeldung:
**09.01.2008 Patentblatt 2008/02**

(60) Teilanmeldung:
**09165796.5 / 2 112 699**

(73) Patentinhaber: **Azzurro Semiconductors AG**
**39106 Magdeburg (DE)**

(72) Erfinder:
• **DADGAR, Armin**
**10555 Berlin (DE)**
• **KROST, Alois**
**13587 Berlin (DE)**

(74) Vertreter: **Eisenführ, Speiser & Partner**
**Anna-Louisa-Karsch-Strasse 2**
**10178 Berlin (DE)**

(56) Entgegenhaltungen:
WO-A2-2004/068572    DE-A1- 10 151 092
US-A1- 2002 190 260    US-A1- 2003 218 179

• **DADGAR A ET AL: "Reduction of stress at the initial stages of GaN growth on Si(111)" APPLIED PHYSICS LETTERS, AIP, AMERICAN INSTITUTE OF PHYSICS, MELVILLE, NY, US, Bd. 82, Nr. 1, 6. Januar 2003 (2003-01-06), Seiten 28-30, XP012033431 ISSN: 0003-6951 in der Anmeldung erwähnt**
• **DADGAR A ET AL: "Bright, crack-free InGaN/GaN light emitters on Si(111)" PHYSICA STATUS SOLIDI A WILEY-VCH GERMANY, Bd. 192, Nr. 2, August 2002 (2002-08), Seiten 308-313, XP002435959 ISSN: 0031-8965**
• **KROST A ET AL: "GaN-based epitaxy on silicon: stress measurements" PHYSICA STATUS SOLIDI A WILEY-VCH GERMANY, Bd. 200, Nr. 1, November 2003 (2003-11), Seiten 26-35, XP002435960 ISSN: 0031-8965 in der Anmeldung erwähnt**
• **KOVALENKO S A ET AL: "Thickness dependences of optical constants for thin layers of some metals and semiconductors" SEMICONDUCTOR PHYSICS QUANTUM ELECTRONICS & OPTOELECTRONICS NATL. ACAD. SCI. UKR UKRAINE, Bd. 4, Nr. 4, 2001, Seiten 352-357, XP002435961 ISSN: 1560-8034**
• **KROST A ET AL: "In situ monitoring of the stress evolution in growing group-III-nitride layers" JOURNAL OF CRYSTAL GROWTH, ELSEVIER, AMSTERDAM, NL, vol. 275, no. 1-2, 15 February 2005 (2005-02-15), pages 209-216, XP004823201 ISSN: 0022-0248**
• **HIRAMATSU K: "Epitaxial lateral overgrowth techniques used in group III nitride epitaxy" JOURNAL OF PHYSICS: CONDENSED MATTER IOP PUBLISHING UK, vol. 13, no. 32, 13 August 2001 (2001-08-13), pages 6961-6975, ISSN: 0953-8984**

EP 1 875 523 B1

**Beschreibung**

Die vorliegende Erfindung betrifft ein Verfahren zur Herstellung einer Schichtstruktur eines Nitridhalbleiterbauelements auf einer Siliziumoberfläche. Weiterhin betrifft die Erfindung ein Verfahren zur Herstellung eines Nitridhalbleiterbauelements. Schließlich betrifft die Erfindung ein Nitridhalbleiterbauelement, insbesondere eine Dünnfilm-Leuchtdiode auf Nitridhalbleiterbasis, sowie ein Nitridhalbleiterprodukt.

Nitridhalbleiter sind Halbleiterverbindungen, die ein oder mehrere Elemente der dritten Hauptgruppe sowie ein oder mehrere Elemente der fünften Hauptgruppe des Periodensystems enthalten. Zu ihnen gehören beispielsweise die Halbleiter GaN, InGaN, InGaAsN, AlGaN etc. Andere übliche Bezeichnungen für Nitridhalbleiter im Sinne der vorliegenden Anmeldung sind Gruppe-III-Nitride, III-V-Nitride. Diese Bezeichnungen werden in der vorliegenden Anmeldung nebeneinander mit gleicher Bedeutung verwendet.

Nitridhalbleiter finden insbesondere in Lichtemitterstrukturen Anwendung, die im sichtbaren und ultravioletten Spektralbereich emittieren. Daneben sind auch elektronische Nitridhalbleiterbauelemente bekannt, wie etwa HEM (engl. high electron mobility)-Transistoren, die insbesondere für Hochfrequenzanwendungen wie beispielsweise in der Funkübertragungstechnik geeignet sind. Nitridhalbleiterbauelemente finden in Form so genannter "Power Devices" auch in der Hochleistungselektronik Anwendung.

Eine kostengünstige Homoepitaxie der Schichtstruktur eines Nitridhalbleiterbauelements ist derzeit aufgrund der geringen Größe und Qualität verfügbarer Substrate aus Nitridhalbleitern kommerziell wenig interessant. Erhältliche Nitridhalbleiterbauelemente, wie etwa blaue oder grüne Leuchtdioden, enthalten daher Schichtstrukturen, die auf Saphir($Al_2O_3$)- oder Siliziumcarbid(SiC)-Substraten abgeschieden werden. Diese Substratmaterialien haben verschiedene Nachteile. Zum einen sind sie teuer. Zum anderen sind gängige Substrate dieser Materialien vergleichsweise klein, so dass die Herstellungskosten pro Bauelement aufgrund der relativ geringen Ausbeute bei gegebener Substratfläche zusätzlich erhöht werden. Dazu kommt die große Härte dieser Materialien, die in der Mohsschen Skala oberhalb von 9 liegt und eine mechanische Bearbeitung nur mit teuren Diamantsägen und -schleifmaterialien ermöglicht.

Daher werden für ein großflächiges Wachstum verstärkt Siliziumsubstrate herangezogen, die bekanntlich mit großem Durchmesser kostengünstig erhältlich sind.

Typische Wachstumstemperaturen für die Schichtstrukturen von Nitridhalbleitern liegen in der kommerziell üblichen Gasphasenepitaxie bei Temperaturen von über 1.000 °C. Unterschiedliche thermische Ausdehnungskoeffizienten von Silizium und Nitridhalbleitermaterialien führen dann beim Abkühlen abgeschiedener Nitridhalbleiterschichtstrukturen nach dem Wachstum zu einem starken tensilen Stress der Nitridhalbleiterschichten von etwa 0,7 GPa/$\mu$m und ab Schichtdicken von weniger als 1 $\mu$m zur Rissbildung.

Zur Vermeidung einer Rissbildung beim Wachstum von GaN-Schichten auf Silizium werden dünne, bei ungewöhnlich tiefen Temperaturen (unter 1000 °C) gewachsene, so genannte Niedertemperatur-AlN- oder AlGaN-Zwischenschichten verwendet. Die Wirkung dieser Schichten beruht auf einer teilweisen Kompensation des tensilen Stress durch Wachstum einer GaN-Schicht mit kompressivem Stress auf der AlN- oder AlGaN-Zwischenschicht. Beim Abkühlen nach der Schichtabscheidung wirkt dieser kompressive Stress der GaN-Schicht dem durch die unterschiedlichen thermischen Expansionskoeffizienten bewirkten tensilen Stress entgegen und führt im Ergebnis zu einem reduzierten tensilen Stress.

Nachteil dieser Technik ist eine hohe Versetzungsdichte in der auf der Zwischenschicht aufwachsenden GaN-Schicht. In der DE 101 51 092 A1, die hiermit durch Referenznahme in die Offenbarung der vorliegenden Anmeldung einbezogen wird, wird daher zur Reduzierung der Versetzungsdichte das zusätzliche Einfügen von Siliziumnitrid-Zwischenschichten in die aufwachsende GaN-Schicht vorgeschlagen. Eine nicht notwendigerweise völlig geschlossene $Si_xN_y$-Zwischenschicht dient als Maskierung für anschließendes Wachstum von GaN. Die Dicke der Zwischenschicht wird gemäß der DE 101 51 092 A1 so gewählt, dass auf ihr nur wenige Wachstumsinseln im Abstand von 100 nm bis zu einigen $\mu$m entstehen, die im weiteren Verlauf des Wachstums bei zunehmendem Abstand der Wachstumsoberfläche von der SiN-Zwischenschicht ab einer so genannten Koaleszenzdicke zusammengewachsen sind und eine geschlossene Schichtoberfläche bilden. Zwar bewirkt erst eine SiN-Zwischenschicht bei der GaN-Epitaxie auf Silizium ein ausgeprägtes Inselwachstum und somit eine nennenswerte Koaleszenzdicke, welche mit zunehmender SiN-Dicke wächst. Durch geeignete Maßnahmen zur Beschleunigung der Koaleszenz dieser Wachstumsinseln kann jedoch verhindert werden, das die erwähnte kritische Rissdicke bereits erreicht wird, bevor die Wachstumsinseln koaleszieren.

Aus dem Dokument A. Dadgar et al., "Reduction of Stress at the Initial Stages of GaN Growth on Si (111)", Applied Physics Letters, Vol. 82, 2003, Nr. 1, Seiten 28-30, (nachfolgend kurz "Dadgar et al."), das hiermit durch Referenznahme in die Offenbarung der vorliegenden Anmeldung einbezogen wird, ist es weiterhin bekannt, GaN-Schichten nach Abscheidung einer Silizium-dotierten AlN-Ankeimschicht und einer SiN-Maskierungsschicht von maximal etwa 1,5 Monolagen nomineller Dicke herzustellen. Gegenüber einem Wachstum ohne eine solche SiN-Maskierungsschicht kann der tensile Stress in der aufwachsenden GaN-Schicht reduziert werden.

Dieser Effekt zeigt als Funktion der SiN-Maskierungsschichtdicke ab einer gewissen Dicke Sättigungserscheinungen und lässt eine vollständige Stress-Kompensation nicht erwarten. Denn zum einen kann die SiN-Maskierungsschicht mit zunehmender Dicke die strukturelle Kopplung zwischen der AIN-Ankeimschicht und der nachfolgend (also nach der SiN-Maskierungsschicht) aufwachsenden GaN-Schicht stören oder sogar verhindern. Im Ergebnis kann dann eine erwünschte kompressive Wirkung der AIN-Ankeimschicht nicht mehr eintreten und es verbleibt eine unerwünscht hohe tensile Verspannung in der fertigen Nitridhalbleiterschicht. Zum anderen erhöht eine dicke SiN-Schicht die Koaleszenzdicke auf Werte, die mit den bekannten Methoden nicht mehr unter der für die Rissbildung kritische Schichtdicke gehalten werden kann.

Im Ergebnis kann demnach auch das Einfügen einer SiN-Maskierungsschicht den tensilen Stress in der Nitridhalbleiter-Schichtstruktur nicht beseitigen.

Inhomogener tensiler Stress hat weitere Nachteile. Er verursacht neben der bereits erwähnten hohen Versetzungsdichte auch eine Krümmung der aufwachsenden Schichtstruktur und des darunter liegenden Substrats. Dieses Problem betrifft auch Dünnschicht-Bauelemente, wie Dünnschicht-Leuchtdioden, bei denen das Siliziumsubstrat im Verlaufe der Herstellung entfernt wird. Schon die Prozessierung gekrümmter Nitridhalbleiterschichtstrukturen bereitet Schwierigkeiten und erhöht daher Aufwand und Kosten der Bauelementfertigung. Eine gekrümmte Nitridhalbleiterschichtstruktur, die dann typischerweise mit einem Träger verbunden wird, löst sich leicht vom Träger, und entsprechende Bauelemente haben eine unerwünscht niedrige Lebensdauer.

Aus dem Dokument C. Mo et al., "Growth and characterization of InGaN blue LED structure on Si(111) by MOCVD", Journal of Crystal Growth, 285 (2005), 312-317 (nachfolgend kurz "Mo et al."), das hiermit durch Referenznahme in die Offenbarung der vorliegenden Anmeldung einbezogen wird, ist es bekannt, den tensilen Stress durch Wachstum einer GaN-Pufferschicht auf der AIN-Ankeimschicht zu reduzieren. Dabei wird für das Wachstum der GaN-Pufferschicht in der Hochtemperatur-Gasphasenepitaxie ein geringes Verhältnis der Gasstromdichten von Galliumprecursor zu Stickstoffprecursor eingestellt. Dies fördert das Inselwachstum der nachfolgenden GaN-Schicht. Nachteilig ist hierbei jedoch, dass weiterhin tensiler Stress in der Nitridhalbleiter-Schichtstruktur verbleibt. Zusätzlich ist diese bekannte Leuchtdiode unerwünscht hochohmig.

Das der vorliegenden Erfindung zugrunde liegende technische Problem ist es daher, ein Verfahren zur Herstellung einer Schichtstruktur eines Nitridhalbleiterbauelements auf einer Siliziumoberfläche und ein Nitridhalbleiterbauelement anzugeben, bei dem der tensile Stress in der fertigen Schichtstruktur gegenüber bekannten Lösungen weiter reduziert ist.

Ein weiteres der vorliegenden Erfindung zugrunde liegendes technisches Problem ist es, ein Verfahren zur Herstellung einer Schichtstruktur eines Nitridhalbleiterbauelements auf einer Siliziumoberfläche und ein Nitridhalbleiterbauelement anzugeben, welches die Krümmung der Nitridhalbleiterschichtstruktur gegenüber vorbekannten Lösungen verringert.

Gemäß einem ersten Aspekt der Erfindung werden die genannten technischen Probleme gelöst durch ein Verfahren zur Herstellung einer Schichtstruktur eines Nitridhalbleiterbauelements auf einer Siliziumoberfläche gemäß dem unabhängigen Anspruch 1.

Mit dem erfindungsgemäßen Verfahren gelingt es überraschender Weise, während des Wachstums der ersten Nitridhalbleiterschicht darin einen erhöhten kompressiven Stress zu erzeugen, der bei geeigneter weiterer Prozessführung sogar eine vollständige oder nahezu vollständige Kompensation des tensilen Stress σ bewirken kann, der durch die unterschiedlichen thermischen Ausdehnungskoeffizienten entsteht. Es kann eine Schichtstruktur gewachsen werden, die nach der Abkühlung bei Raumtemperatur entweder völlig verspannungsfrei oder- mit einem Wert von σ, der jedenfalls deutlich unter 0.2 GPa/$\mu$m, in aller Regel jedoch sogar unter 0.1 GPa/$\mu$m liegt - nahezu verspannungsfrei ist und darüber hinaus eine sehr geringe Versetzungsdichte und nur sehr wenige oder gar keine Risse aufweist.

Das erfindungsgemäße Verfahren eignet sich zugleich zur Herstellung von Schichtstrukturen mit besonders hohem oder sogar unendlichem Krümmungsradius, die insbesondere in der Herstellung von Dünnfilm-Bauelementen wie Leuchtdioden von großem Vorteil sind.

Damit wird ein kostengünstiges Wachstum von Dünnfilm-Bauelementen auf Nitridhalbleiter-Basis auch auf großformatigen Silizium- oder SOI (Silicon-on-Insulator)-Wafern ermöglicht.

Diese Vorteile sind vermutlich darauf zurückzuführen, dass die zusammenwachsenden Kristallite oberhalb einer geeignet abgeschiedenen Maskierungsschicht, die bevorzugt aus SiN besteht, während des Wachstums mit Erreichen einer durchschnittlichen Kristallitfläche von 0,16 $\mu$m$^2$ und mehr in der Nitridhalbleiterschicht durch ihr Zusammenwachsen einen ausreichend starken kompressiven Stress erzeugen. Dieser stärkere kompressive Stress kann den später bislang unbekannt hinzukommenden tensilen Stress besser kompensieren.

Die durchschnittliche Kristallitfläche der Kristallite in einer Schichtebene oberhalb der Koaleszenzschichtdicke in einer Nitridhalbleiterschicht lässt sich durch mit Hilfe eines bildgestützten Analyseverfahrens wie beispielsweise einer Auswertung von plan-view transmissionselektronenmikroskopischen (TEM) Aufnahmen ermitteln, wie es weiter unten anhand zweier Beispiele näher erläutert wird. Der Analyse ist selbstverständlich eine ausreichend große Stichprobe von Kristalliten zugrunde zu legen.

Der bisherige Stand der Technik ließ aufgrund der beobachteten, oben beschriebenen Sättigungseffekte bei Verwendung einer SiN-Maskierungsschicht (Dadgar et al.) und der beobachteten und ebenfalls oben beschriebenen, nur partiellen Stressreduktion bei Verwendung einer GaN-Pufferschicht (Mo et al.) das Auftreten dieses Effektes und die Möglichkeit einer nahezu vollständigen Stresskompensation nicht erwarten. Dieser überraschende Effekt wird gemäß der vorliegenden Erfindung zur Herstellung besonders gering verspannter oder völlig unverspannter Nitridhalbleiterschichtstrukturen auf Siliziumoberfläche genutzt, aus denen anschließend besonders vorteilhafte Nitridhalbleiterbauelemente hergestellt werden können.

Wenn in den Ansprüchen von einer aluminiumhaltigen Nitridschicht mit jeweiliger Funktion (Ankeimschicht, Pufferschicht, Zwischenschicht etc.) gesprochen wird, so ist darunter eine Schicht der jeweiligen Funktion zu verstehen, die Aluminium entweder als alleiniges Gruppe-III-Metall enthält oder in einer Kombination mit anderen Gruppe-III-Metallen. Von Dotierungen mit Elementen anderer Gruppen des Periodensystems, etwa mit Silizium oder Magnesium, wird zum Zwecke der Definition hier abgesehen. Selbstverständlich können jedoch auch solche Dotierstoffe enthalten sein.

Eine Ankeimschicht ist eine nur wenige Nanometer dicke, nicht zwingend geschlossene Schicht, die trotz eventuell schlechter kristalliner und/oder stöchiometrischer Eigenschaften eine Grundlage für ein anschließendes Schichtwachstum der darauf aufwachsenden Schicht bildet, oder von der ein weiteres Schichtwachstum ausgeht.

Eine Maskierungsschicht dient zur vollständigen oder teilweisen Abdeckung einer Oberfläche und ist häufig nur wenige Monolagen oder sogar weniger als eine Monolage dick.

Ein zweiter Aspekt der vorliegenden Erfindung betrifft ein Verfahren zur Herstellung eines Nitridhalbleiterbauelements gemäß dem Anspruch 14.

Das Verfahren gemäß dem zweiten Aspekt der Erfindung ist eine vorteilhafte Weiterbildung des Verfahrens des ersten Aspekts der Erfindung und ermöglicht eine besonders einfache und kostengünstige Prozessierung von Nitridhalbleiterbauelementen.

Gemäß einem dritten Aspekt der Erfindung werden die oben genannten technischen Probleme gelöst durch ein Nitridhalbleiterbauelement gemäß dem unabhängigen Anspruch 26.

Solche Bauelemente, die eine für die Herstellung auf einer Siliziumoberfläche charakteristische Struktur der Nitridhalbleiterschicht aufweise, haben bei geringen Herstellungskosten eine für kommerzielle Anwendungen unerlässliche lange Lebensdauer und günstige Betriebsparameter.

Das Nitridhalbleiterbauelement des dritten Aspekts der Erfindung hat Strukturmerkmale, die für die erfindungsgemäße Verfahrensführung charakteristisch sind und es erlauben, ein nach diesem Verfahren hergestelltes Nitridhalbleiterbauelement von anderen Nitridhalbleiterbauelementen zu unterscheiden.

So ist es zwar grundsätzlich auch möglich und an sich bekannt, Kristallite mit einer großen durchschnittlichen Fläche bei Verwendung eines Saphir-Substrats zu erzeugen. Jedoch weisen auf Saphir-Substrat hergestellte Nitrithalbleiterbauelemente, die keine über 100 nm dicken AIGaN-Schichten enthalten, keine aluminiumhaltigen Nitridhalbleiterzwischenschichten, insbesondere keine Aluminiumnitrid-Zwischenschichten auf. Das Wachstum von Halbleiterschichten auf Saphir-Substrat unterliegt völlig anderen Randbedingungen als das Wachstum auf Siliziumsubstrat, wie es in der vorliegenden Erfindung beschrieben ist. Denn das Schichtwachstum auf Saphir-Substrat führt stets zu einer biaxial kompressiv verspannten Schicht nach dem Abkühlen. Ein Strain-Engineering mit Hilfe von aluminiumhaltigen Nitridzwischenschichten, das zu einer kompressiven Verspannung der GaN Schichten während des Wachstums führt, ist dort nicht erforderlich und bei LED Strukturen sogar unerwünscht, da dies zu einer sehr starken Substratkrümmung während des Wachstums der InGaN Schicht um 800 °C und am Ende des Prozesses führt. Wie eingangs erläutert, ist es an sich auch bekannt, beim Wachstum von Nitridhalbleiterschichten auf Silizium aluminiumhaltige Nitridhalbleiterzwischenschichten für das Strain-Engineering zu verwenden.

Doch eine Kombination dieser beiden Merkmale war bislang technisch nicht erreichbar. Erst mit der Verfahrensführung gemäß dem ersten Aspekt der vorliegenden Erfindung ist es gelungen, Schichten mit Kristalliten einer ausreichend großen Fläche auf Silizium-Substrat zu erzeugen. Bei fortgesetztem Wachstum dieser Nitridhalbleiterschichten für die Herstellung dickerer Nitridhalbleiterschichten von mehr als etwa 1300 nm Dikke werden allein für das Wachstum auf der Grundlage eines Substrates mit Siliziumoberfläche Strain-Engineering-Zwischenschichten erforderlich, um so während des Wachstums einen ausreichend großen kompressiven Stress einzustellen, der beim abschließenden Abkühlen einen dann auftretenden tensilen Stress vollständig oder nahezu vollständig kompensieren kann. In der Fachwelt war es bislang nicht möglich, ein Nitridhalbleiterbauelement gemäß dem vorliegenden dritten Aspekt der Erfindung herzustellen.

Die beim Abscheiden auf der Siliziumoberfläche zunächst hergestellten Schichten, nämlich die aluminiumhaltige Nitridankeimschicht und die Maskierungsschicht werden für eine Herstellung von Dünnfilm-Bauelementen wie Dünnfilm-LEDs nach der Ablösung der gewachsenen Schichten von der Siliziumoberfläche im Rahmen der weiteren Prozessierung typischerweise entfernt. Daher können mit dem erfindungsgemäßen Verfahren Nitridhalbleiterbauelemente hergestellt werden, denen man die erfindungsgemäße Verfahrensführung zwar nicht am Vorhandensein der Ankeim- und Maskierungsschichten nachweisen kann, bei denen jedoch das Vorliegen von aluminiumhaltigen Nitridhalbleiterzwischenschichten in der Schichtstruktur einen eindeutigen Hinweis auf die Verwendung eines Siliziumsubstrats beim Wachstum liefert.

Gemäß einem vierten Aspekt der Erfindung werden die oben genannten technischen Probleme gelöst durch ein Nitridhalbleiterprodukt gemäß dem unabhängigen Anspruch 44.

Das Nitridhalbleiterprodukt der Erfindung ist typischerweise ein selbstständig handelbares Zwischenprodukt der Bauelementfertigung. Es kann zur Herstellung von Bauelementen sowohl auf dem vorhandenen Substrat mit Siliziumoberfläche als auch, nach Ablösen des Substrats, auf einem anderen Träger genutzt werden, oder für die Herstellung großflächiger freitragender Schichten, großflächiger Nitridhalbleiter-Substrate oder freitragender Bauelemente.

Nachfolgend werden Ausführungsbeispiele der verschiedenen Verfahrens- und Vorrichtungsaspekte der vorliegenden Erfindung beschrieben. Die Ausführungsbeispiele können miteinander kombiniert werden, soweit dies nicht ausdrücklich ausgeschlossen ist.

Zunächst werden Ausführungsbeispiele des Verfahrens zur Herstellung einer Schichtstruktur eines Nitridhalbleiterbauelements auf einer Siliziumoberfläche gemäß dem ersten Aspekt der Erfindung beschrieben.

Mit besonders großen Kristallitflächen wird die Schichtqualität verbessert. Bei einem bevorzugten Ausführungsbeispiel wird die Maskierungsschicht daher derart abgeschieden, dass im Abscheideschritt der ersten Nitridhalbleiterschicht zunächst getrennte Kristallite wachsen, die oberhalb einer Koaleszenzschichtdicke zusammenwachsen und in einer Schichtebene der zusammengewachsenen Nitridhalbleiterschicht senkrecht zur Wachstumsrichtung eine durchschnittliche Fläche von $0.16 \mu m^2$ bis $0{,}36 \mu m^2$ einnehmen.

Bei dem bevorzugten Ausführungsbeispiel wird die Maskierungsschicht mit einer Schichtdicke abgeschieden, die bei der zunächst in Form von Wachstumsinseln aufwachsenden ersten Nitridhalbleiterschicht Frühestens ab einem Abstand von mindestens 600 nm von der Maskierungsschicht eine zu mehr als 95% geschlossene Schichtfläche entstehen lässt. Die Prozessführung dieses Ausführungsbeispiels hat in Untersuchungen mit guter Reproduzierbarkeit zu galliumhaltigen Nitridhalbleiterschichten geführt, die oberhalb einer Schichtdicke von 600 nm weitestgehend zusammengewachsen sind und in Schichtebenen oberhalb dieses Abstandes von der Keimschicht großflächige Kristallite aufweisen, deren durchschnittliche Fläche oberhalb von $0{,}16 \mu m^2$ liegt.

Bevorzugt wird bei der erfindungsgemäßen Prozessführung und insbesondere bei der Prozessführung bei dem eben beschriebenen Ausführungsbeispiel von einer Maskierungsschicht ausgegangen, die eine Bedeckung der darunter liegenden Nitridankeimschicht oder, wenn vorhanden, der ersten Nitridpufferschicht von mindestens 95 % aufweist. Bei diesem Bedeckungsgrad entstehen oberhalb der Maskierungsschicht relativ wenige Wachstumskeime, die sich im Verlaufe der weiteren Schichtabscheidung durch ein dreidimensionales Wachstum (Inselwachstum) zu großen Kristalliten entwickeln können.

Die besten Ergebnisse wurden bisher mit Maskierungsschichten aus Siliziumnitrid erzielt. Grundsätzlich ist es jedoch auch denkbar, andere geeignete Materialien für die Maskierungsschicht zu verwenden, wie etwa Anti-Surfactands, die also eine Benetzung der Ankeimschicht verhindern. Hier könnten prinzipiell beispielsweise alle Metall-Nitride, die bei den hohen Wachstumstemperaturen der Nitridhalbleiterabscheidung verwendet werden, geeignet sein. Stoffe, die amorph aufwachsen, sind aber eher geeignet, da auf solchen Oberflächen oft keine oder nur eine verzögerte Bekeimung stattfindet.

Die Verfahrensführung wird in einem bevorzugten Ausführungsbeispiel durch eine mitlaufende Messung der Reflexionsintensität der Wachstumsoberfläche begleitet (Reflektometrie). Dieses an sich bekannte Verfahren zur Überwachung des Schichtwachstums ermöglicht eine Kontrolle und definierte Einstellung der Dauer der Abscheidung der Maskierungsschicht, die bevorzugt so gewählt wird, dass beim Abscheideschritt der ersten Nitridhalbleiterschicht die mitlaufende Messung der Reflexionsintensität der Wachstumsoberfläche bei einer Lichtwellenlänge von ca. 600 nm einen oszillierenden Intensitätsverlauf mit ansteigender Oszillationsamplitude zeigt, die nach frühestens fünf Oszillationszyklen einen dann etwa gleichbleibenden Maximalwert erreicht. Der genaue Wert der Dauer der Abscheidung der Maskierungsschicht hängt von zahlreichen Parametern ab, die von Wachstumsreaktor zu Wachstumsreaktor variieren können. Mit der Anleitung des vorliegenden Ausführungsbeispiels kann in wenigen Experimenten eine geeignete Dauer der Abscheidung der Maskierungsschicht für einen jeweiligen Wachstumsreaktor ermittelt werden.

Schon die erste Nitridhalbleiterschicht wächst gemäß dem erfindungsgemäßen Verfahren mit kompressivem Stress auf. Es werden bevorzugt keine die Koaleszenz fördernden Wachstumsparameter (wie beispielsweise eine erhöhte Wachstumstemperatur oder ein hohes V/III-Verhältnis) eingestellt. Unter diesen Bedingungen erhält man ein besonders kompressives Schichtwachstum und kann damit einen geringeren tensilen Stress nach dem Abkühlen und somit eine homogen verspannte bzw. unverspannte Nitridhalbleiter-Schichtstruktur herstellen.

Soll ein Nitridhalbleiter mit einer höheren Schichtdicke abgeschieden werden, wird die erste Nitridhalbleiterschicht vorzugsweise mit einer Schichtdicke von 800 - 1600 nm abgeschieden, bevor nachstehend erläuterte weitere Schichten aufgewachsen werden, die zu der höheren Schichtdicke führen. Bevorzugt wird dann nämlich auf der ersten Nitridhalbleiterschicht eine aluminiumhaltige Nitridzwischenschicht abgeschieden und anschließend auf letzterer Schicht eine galliumhaltige weitere Nitridhalbleiterschicht abgeschieden, die auch als zweite Nitridhalbleiterschicht bezeichnet wird. Mit der aluminiumhaltigen Nitridzwischenschicht, die im Falle des Wachstums von GaN als erster Nitridhalbleiterschicht bevorzugt eine Niedertemperatur-AIN-Schicht ist, kann der kompressive Stress in der Schichtstruktur weiter erhöht werden. Die Funktion der aluminiumhaltigen Nitridzwischenschicht ist also das Strain-Engineering.

Die Schrittfolge der Abscheidung einer aluminiumhaltigen Nitridzwischenschicht und einer galliumhaltigen weiteren Nitridhalbleiterschicht kann wiederholt durchgeführt werden. Auf diese Weise können der ersten Nitridhalbleiterschicht eine zweite, dritte, vierte usw. Nitridhalbleiterschicht folgen, jeweils mit davor abgeschiedenen aluminiumhaltigen Zwischenschichten. Es ergibt sich, abgesehen von den Nitridzwischenschichten, eine dicke Nitridhalbleiterschicht, die sich aus der ersten, zweiten, ggf. dritten, usw. Nitridhalbleiterschicht zusammensetzt. Bei Bedarf können hierin selbstverständlich weitere Zwischenschichten mit anderer Funktion eingefügt werden.

Die Dicke der aluminiumhaltigen Nitridzwischenschicht beträgt beispielsweise im Falle der Verwendung einer Niedertemperatur-AIN-Zwischenschicht 8 bis 15 nm. Denkbar ist auch die Verwendung einer AIGaN-Zwischenschicht, wobei hier in etwa dieselben Schichtdicken geeignet sind. Aus der DE 10 2004 038 573 A1 der Anmelderin ist die Verwendung von dickeren, bei hohen Temperaturen gewachsenen AIN-Zwischenschichten für Strain-Engineering-Zwecke bekannt. Zu beachten hierbei ist, dass erfahrungsgemäß ab einer Dicke dieser Schicht von ca. 30 nm eine Tendenz zur Bildung einer hochohmigen Schichtstruktur entsteht, was für die Herstellung von Lichtemittern nachteilig ist. Auch nimmt die Neigung zur Rissbildung zu.

Wird auf die Verwendung von aluminiumhaltigen Nitridzwischenschichten verzichtet, wird die erste Nitridhalbleiterschicht vorzugsweise mit einer Dicke von 1300 nm (für den Fall GaN) abgeschieden. Oberhalb dieser Schichtdicke können beim Abkühlen aufgrund der dann auftretenden tensilen Spannungskomponente Risse auftreten.

Zur Herstellung lichtemittierender Nitridhalbleiterbauelemente wird bevorzugt auf der zweiten oder, nach Verfahrensführung mit einer oben erläuterten wiederholten Schichtabscheidung, einer anderen weiteren Nitridhalbleiterschicht eine Multi-Quantum-Well-Struktur aus Nitridhalbleitermaterial abgeschieden. Multi-Quantum-Well-Strukturen für lichtemittierende Nitridhalbleiterbauelemente sind an sich bekannt und brauchen hier nicht näher erläutert werden.

Es hat sich gezeigt, dass das Abscheiden mindestens einer zweiten Maskierungsschicht aus Silizium unmittelbar vor dem Abscheiden derjenigen der weiteren Nitridhalbleiterschichten, auf der die Multi-Quantum-Well-Struktur abgeschieden wird, eine besonders gute Schichtqualität in dem für die Lichtemission entscheidenden Bereich der Schichtstruktur erzielt.

Zur Herstellung eines optoelektronischen Bauelements wird vorzugsweise in die erste und, wenn vorhanden, diejenigen weiteren Nitridhalbleiterschichten, die vor der Multi-Quantum-Well-Struktur abgeschieden werden, eine n-Dotierung eingebracht. Zur Herstellung einer p-dotierten Zone wird vorzugsweise auf der Multi-Quantum-Well-Struktur eine p-dotierte galliumhaltige Nitridhalbleiterdeckschicht abgeschieden.

Insbesondere für das Wachstum dicker Schichtstrukturen ist das Problem zu beachten, dass ein in der Nitridhalbleiterschichtstruktur entstehender Stress auch auf das Substrat wirkt und zu einer Substratkrümmung führen kann. Eine solche Krümmung ist auch von anderen Heterosubstraten, wie beispielsweise Saphir bekannt. Die Reduzierung dieser Krümmung beinhaltet in einem bevorzugten Ausführungsbeispiel den Schritt des Bereitstellens eines Substrats das Bereitstellens eines insbesondere leitfähigen Siliziumsubstrats, dessen Dicke mindestens $D_{GaN}{}^{*}x$ beträgt, wobei $D_{GaN}$ die Schichtdicke der auf dem Substrat abzuscheidenden Nitridhalbleiterschicht oder, wenn mehr als eine Nitridhalbleiterschicht abzuscheiden ist, die Summe der Schichtdicken der auf dem Substrat abzuscheidenden Nitridhalbleiterschichten und der vorhandenen Nitridzwischenschicht bezeichnet, und wobei x im Falle der Verwendung eines dotierten Siliziumsubstrats mindestens 110 und im Falle der Verwendung eines undotierten Substrats mindestens 200 beträgt. Mit diesen Werten der Schichtdicke gelingt es jeweils, die durch die kompressive Vorspannung im Si-Substrat mögliche plastische Deformation zu verhindern. Dies ist vorteilhaft, weil ein auf diese Weise verformter Kristall nicht mehr plan werden könnte.

Dieses zusätzliche Merkmal des vorliegenden Ausführungsbeispiels stellt einen selbstständig schutzwürdigen Erfindungsgedanken dar. Ein selbstständig schutzwürdiges Verfahren zur Herstellung einer Schichtstruktur eines Nitridhalbleiterbauelements auf einer Siliziumoberfläche beinhaltet demnach den Schritt des Bereitstellens eines Siliziumsubstrats entsprechend dem zusätzlichen Merkmal des zuletzt genannten Ausführungsbeispiels. Die weiteren Schritte des Verfahrens des ersten Aspekts der Erfindung sowie die hier beschriebenen Ausführungsformen des Verfahrens des ersten Aspekts der Erfindung bilden Ausführungsbeispiele dieses selbstständig schutzwürdigen Verfahrens. Gerade bei stärker verspannten Schichtstrukturen kann mit dem Verfahren dieser selbstständigen Erfindung verhindert werden, dass sich das Siliziumsubstrat zu stark krümmt.

Das vorstehende Ausführungsbeispiel wird zusätzlich verbessert, wenn das Siliziumsubstrat eine Dicke aufweist, die zusätzlich größer oder gleich $100 * \sqrt{D_{GaN}} * y$ ist, wobei

$$y = \frac{Substratdurchmesser\_in\_cm}{3.5}$$ Diese zusätzliche Bedingung ist insbesondere bei Leuchtdioden mit InGaN oder AIGaN-Schichten von Vorteil.

Nachfolgend werden Ausführungsbeispiele des Verfahrens gemäß dem zweiten Aspekt der Erfindung beschrieben, das die Herstellung eines Nitridhalbleiterbauelements betrifft. Dieses Verfahren enthält alle Schritte des Verfahrens des ersten Aspekts der Erfindung und teilt somit auch dessen Vorteile.

Bei einem bevorzugten Ausführungsbeispiel dieses Verfahrens nach dem zweiten Aspekt der Erfindung wird eine elektrisch leitfähige Kontaktschicht auf der Wachstumsoberseite der nach dem Verfahren gemäß dem ersten Aspekt der Erfindung hergestellten Schichtstruktur abgeschieden.

In einem ersten von zwei nachfolgend beschriebenen alternativen Ausführungsbeispielen hat die Kontaktschicht einen höheren Brechungsindex als die p-dotierte Nitridhalbleiterdeckschicht. Die Kontaktschicht kann zusätzlich metallisiert werden, ebenso wie die Wachstumsoberseite der Nitridhalbleiterschichtstruktur, wenn keine Kontaktschicht vorhanden ist. Auf diese Weise wird die Lichtausbeute des Nitridhalbleiterbauelements erhöht. Bei diesem ersten alternativen Ausführungsbeispiel mit einer Kontaktschicht, deren Brechungsindex größer als der der p-dotierten Nitridhalbleiterdeckschicht ist, wird diese Nitridhalbleiterdeckschicht vorzugsweise mit einer Dicke von

$$m \cdot \frac{\lambda}{2 \cdot n_{Nitrid}} + \frac{\lambda}{4 \cdot n_{Nitrid}} - \frac{d_{MQW}}{2} \quad \text{abgeschieden}$$

wird, wobei m = 0, 1, 2, 3, ...; $\lambda$ eine Wellenlänge einer Lichtemission der Multi-Quantum-Well-Struktur im Betrieb des Nitrid-Halbleiterbauelements, $n_{Nitlid}$ den Brechungsindex des Nitrids bei der Wellenlänge $\lambda$ und $d_{MQW}$ die Dicke der Multi-Quantum-Well-Struktur bezeichnet. Dies erhöht die Lichtausbeute, wenn die Nitridhalbleiterdeckschicht im fertigen Bauelement in Material mit n>n (Nitrid) eingebettet ist. Hierzu zählen Metalle oder höherbrechende Materialien, beispielsweise höherbrechende Halbleiter.

Im zweiten der beiden alternativen Ausführungsbeispiele hat die Kontaktschicht einen geringeren Brechungsindex als die p-dotierte Nitridhalbleiterdeckschicht. Bei diesem Ausführungsbeispiel wird die Nitridhalbleiterdeckschicht vorzugsweise mit einer Dicke von

$$m \cdot \frac{\lambda}{2 \cdot n_{Nitrid}} - \frac{d_{MQW}}{2} \quad \text{abgeschieden, wobei m = 1,}$$

2, 3, 4, ...; $\lambda$ eine Wellenlänge einer Lichtemission der Multi-Quantum-Well-Struktur im Betrieb des Nitrid-Halbleiterbauelements, $n_{Nitrid}$ den Brechungsindex des Nitrids bei der Wellenlänge $\lambda$ und $d_{MQW}$ die Dicke der Multi-Quantum-Well-Struktur bezeichnet. Diese Formel gilt für den Fall der Abdeckung der Nitridhalbleiterdeckschicht mit einem Material mit kleinerem Brechungsindex, wie z. B. verschiedene Kunststoffe, Luft etc.. Dies ist der üblichere Fall bei Standard LEDs, nicht jedoch bei abgelösten LEDs.

Es hat sich als besonders vorteilhaft herausgestellt, einen Träger zu verwenden, dessen zum Bonden verwendete Oberfläche elektrisch leitfähig, reflektierend oder metallisch ist. Bekanntlich verbinden die meisten Metalle diese Eigenschaften in vorteilhafter Weise. Auf diese Weise wird die Wärmeabfuhr aus dem Bauelement verbessert. Vorzugsweise ist die metallische Oberfläche oder der gesamte Träger aus Kupfer, Aluminium, Aluminiumnitrid, Silizium oder Aluminium-Silizium bzw. Aluminium-Silizium-Kohlenstoff gebildet.

Ein besonders geeignetes anderes Trägermaterial ist Aluminium-Silizium (Al/Si) mit hohem, idealerweise über mindestens 70% liegendem Siliziumgehalt, eine elektrisch und thermisch sehr gut leitende Verbindung mit, anders als Kupfer oder Aluminium, nahezu identischem Ausdehnungskoeffizienten im Vergleich zu GaN bzw. bei höherem Si-Gehalt sogar identischem Ausdehnungskoeffizienten. Dies verhindert Probleme beim Montieren und Betreiben der LEDs, da die dabei auftretenden Verspannungen zum Ablösen des Bauelements oder Reißen der Schicht führen können. Derzeit werden daher beispielsweise LEDs auf Al-Trägern mit elastischen Klebern befestigt, da nur so die stark unterschiedlichen thermischen Ausdehnungskoeffizienten (GaN - 5.6 ppmK$^{-1}$, Al > 20 ppmK$^{-1}$) beherrscht werden können. Die Verwendung elastischer Kleber hat jedoch Nachteile. Eine weitere selbständig schutzwürdige Erfindung bildet demnach die Verwendung eines Al/Si-Trägers für die Herstellung eines Licht emittierenden Dünnfilm-Nitridhalbleiterbauelements, sowie ein Licht emittierendes Dünnfilm-Nitridhalbleiterbauelement mit einem Al/Si-Träger als solches, wobei die Zusammensetzung des Al/Si-Trägers erfindungsgemäß so gewählt ist, dass er einen identischen oder nahezu identischen thermischen Ausdehnungskoeffizienten wie das Nitridhalbleitermaterial des Bauelements hat. Die Nachteile elastischer Kleber können mit einem Al/Si-Träger (Ausdehnungskoeffizient von AlSi(30/70) beispielsweise 7.5 ppmK$^{-1}$) gänzlich vermieden werden. Die Wärmeleitung dieses Trägermaterials ist immerhin halb so gut wie die von Aluminium und damit um mehr als eine Größenordnung besser als die von Si.

Das Bonden wird vorzugsweise bei niedrigen Temperaturen durchgeführt, die in einem Bereich zwischen 280 und 500 °C liegen. Besonders bevorzugt ist derzeit eine Temperatur von 280 °C. Auf diese Weise werden beim Abkühlen nach dem Bonden keine bzw. nur geringe zusätzlichen Verspannungen erzeugt. Unterhalb von 280 °C wird das Metall nicht flüssig. Eine Temperatur von 500 °C stellt für manche Träger wegen eventuell auftretendem Stress eine tendenziell schon kritische Obergrenze dar, kann aber bei anderen Trägern noch sinnvoll sein. Bei höheren Temperaturen als 500 °C kann je nach verwendetem Material auch das Kontaktmetall stark leiden.

Das Entfernen des Substrats beim Verfahren des zweiten Aspekts der vorliegenden Erfindung erfolgt vorzugsweise durch Abschleifen. Zusätzlich kann nass- oder trockenchemisches Ätzen eingesetzt werden.

In einem weiteren Ausführungsbeispiel wird die durch Entfernen des Substrats freigelegte Wachstumsrückseite zur Bildung einer antireflektiv wirkenden Schicht strukturiert. Dies kann beispielsweise sehr einfach durch Ätzen mit KOH (Kaliumhydroxid) vom N-face , also dem Stickstoffface (000-1) des Materials her erfolgen und ergibt bei geeigneter Prozessführung gut geeignete Strukturen, die etwa pyramidenförmig sind.

Gemäß einer alternativen Prozessführung, die auch eine vierte selbstständig schutzwürdige Erfindung bildet, wird das Substrat nach der beschriebenen Prozessführung gemäß dem zweiten Aspekt der Erfindung oder eines seiner Ausführungsbeispiele nicht vollständig, sondern auf eine verbleibende Schichtdicke von 3-10 $\mu$m gedünnt und dann oxidiert. Die so entstandene Siliziumoxidschicht wird als transparente Schicht rauh strukturiert. Das Verfahren umfasst also die Schritte

- Herstellung einer Schichtstruktur eines Nitrid-Halbleiterbauelements auf einer Siliziumoberfläche;

- Bonden der Schichtstruktur mit einem Träger derart, dass die Wachstumsoberseite der Schichtstruktur dem Träger zugewandt ist;

- Entfernen des Substrats bis auf eine dünne Siliziumschicht, die vorzugsweise 5 bis 10 $\mu$m dick ist;

- Oxidieren der Siliziumschicht zur Bildung einer Siliziumdioxid-Schicht;

- Herstellen einer Kontaktstruktur.

Diese Verfahrensführung hat den Vorteil, dass sie für eine verbesserte Lichtauskopplung genutzt werden kann. Darüber hinaus bewirkt die Oxidation des Siliziumsubstrats eine Ausdehnung des ehemaligen Substrats und somit in der Folge eine leicht kompressive Verspannung der Nitridhalbleiter (beispielsweise GaN) - Schicht. Dies ist besonders dann von Vorteil, wenn diese GaN-Schicht leicht zugverspannt ist. Durch die Druckverspannung wird somit ein Reißen und Verbiegen der GaN-Schicht sicher vermieden. Der durch das Verbleiben des oxidierten Si-Substrats dickere Schichtstapel mit Dicken im Bereich von 6 - 20 $\mu$m weist insbesondere eine höhere mechanische Festigkeit auf, was die Herstellung der Bauelemente vereinfacht.

Nachfolgend werden Ausführungsbeispiele des erfindungsgemäßen Nitridhalbleiterbauelements gemäß dem dritten Aspekt der Erfindung beschrieben, soweit sie sich nicht schon unmittelbar aus den oben beschriebenen Ausführungsbeispielen des erfindungsgemäßen Verfahrens ergeben. Bevorzugt enthält das Nitridhalbleiterbauelement einen Träger der Nitridhalbleiterschichtstruktur, der vom Substrat verschieden ist, auf dem die Schichtstruktur gewachsen wurde. Ein besonders geeigneter Träger besteht im Wesentlichen aus Kupfer, Aluminium oder Al/Si. Auf diese Weise wird die Ableitung von Wärme verbessert, die beim Betrieb des Nitridhalbleiterbauelements erzeugt wird.

Ausführungsbeispiele mit p- und n-dotierten Bereichen, wie sie für lichtemittierende Halbleiterbauelemente (LEDs, Laserdioden), aber auch für elektronische Bauelemente (Transistoren, etc.) üblich sind, werden in einem bevorzugten Ausführungsbeispiel mit jeweils einem elektrischen Kontaktelement versehen.

Ein weiteres bevorzugtes Ausführungsbeispiel enthält mindestens eine weitere Maskierungsschicht aus Siliziumnitrid unmittelbar angrenzend an diejenige der weiteren Nitridhalbleiterschichten angeordnet, auf der die Multi-Quantum-Well-Struktur abgeschieden ist, jedoch an der von der Multi-Quantum-Well-Struktur abgewandten Seite dieser weiteren Nitridhalbleiterschicht. Auf diese Weise wird die Schichtqualität in dem Bereich des Bauelements verbessert, der der Multi-Quantum-Well-Struktur am nächsten liegt und daher einen großen Einfluss auf die Ladungsträgerlebensdauer hat. Durch eine Verbesserung der Schichtqualität kann eine längere Ladungsträgerlebensdauer erzielt werden, was auf das Unterdrücken von unerwünschter Rekombination an Defekten zurückzuführen ist.

Ein Zwischenprodukt, das bei der Herstellung des erfindungsgemäßen Nitridhalbleiterbauelements erzeugt wird, ist eine Trägerscheibe, auf der eine Vielzahl erfindungsgemäßer Nitridhalbleiterbauelemente angeordnet ist. Die Trägerscheibe bildet ein Zwischenprodukt, das mit einem prozessierten Wafer der Siliziumtechnologie vergleichbar ist. Die Vereinzelung der auf der Trägerscheibe angeordneten Nitridhalbleiterbauelemente kann beim Hersteller der insoweit prozessierten Trägerscheibe selbst oder nach einem Transport bei einem Bauelementhersteller erfolgen.

Der Vorteil der Erfindung liegt bei diesem Aspekt darin, dass besonders große Trägerscheiben verwendet werden können, denn das erfindungsgemäße Verfahren kann auf großen, kommerziell weit verbreiteten Silizium-Wafern durchgeführt werden. Nach Abtrennen der auf den Silizium-Wafer aufgewachsenen Nitridhalbleiter-Schichtstruktur kann diese mit einer Trägerscheibe entsprechender Größe verbunden werden. Die Erfindung ermöglicht daher eine besonders kostengünstige Herstellung von Bauelementen. Die Nitridhalbleiterbauelemente können auf dem Träger beispielsweise in ihrer Gesamtheit eine laterale Erstreckung von mindestens 24 cm haben.

Nachfolgend werden Ausführungsbeispiele des Nitridhalbleiterprodukts gemäß dem vierten Aspekt der Erfindung beschrieben, soweit sie sich nicht unmittelbar aus den zuvor beschriebenen Ausführungsbeispielen der anderen Aspekte der Erfindung ergeben.

In einem bevorzugten Ausführungsbeispiel hat das Nitridhalbleiterprodukt eine, am Substrat in einer zur rückseitigen Substratfläche senkrechten Richtung messbare Krümmung, die einem Krümmungsradius von mindestens 10 m oder einem unendlich großen Krümmungsradius entspricht. Derart hohe Krümmungsradien sind mit der erfindungsgemäßen Verfahrensführung möglich, wenn durch das Einfügen von Niedertemperatur-Strain-Engineering-Zwischenschichten ein ausreichend hoher kompressiver Stress während des Wachstums erzeugt wird, der beim nachfolgenden Abkühlen durch den dann entstehenden tensilen Stress möglichst genau kompensiert wird.

Weitere Ausführungsbeispiele und Vorteile der Erfindung ergeben sich aus der nachfolgenden Beschreibung der beiliegenden Figuren. Es zeigen:

Fig. 1 ein Ausführungsbeispiel eines Nitridhalbleiterproduktes, das ein Zwischenprodukt bei der Herstellung eines erfindungsgemäßen Nitrid- halbleiterbauelements bildet;

Fig. 2 ein Diagramm, das die Entwicklung des Krümmungsradius des Halb- leiterprodukts der Fig. 1 während seiner Herstellung, sowie im Ver- gleich den Krümmungsradius eines Nitridhalbleiterprodukts nach dem Stand der Technik während seiner Herstellung;

Fig. 3 ein Diagramm, mit der zeitlichen Entwicklung der von der Wachs- tumsoberfläche des Nitridhalbleiterprodukts während seiner Herstel- lung reflektierten Lichts;

Fig. 4a) und b) Differenz-Interferenzkontrastmikroskop(DIC)-Aufnahmen von GaN-Schichten, die mit Verfahren gemäß dem Stand der Tech- nik hergestellt wurden;

Fig. 4c) eine DIC-Aufnahme einer GaN-Schicht, die mit einem erfindungsgemäßen Verfahren hergestellt wurde;

Fig. 5a) eine In-Plane-Transmissionelektronenmikroskop-Aufnahme einer GaN-Schicht, die mit einem Verfahren nach dem Stand der Technik hergestellt wurde;

Fig. 5b) eine In-Plane-Transmissionelektronenmikroskopische Aufnahme einer GaN-Schicht, die mit einem erfindungsgemäßen Verfahren hergestellt wurde; und

Fig. 6a) - 6f) unterschiedliche Verfahrensstadien bei der Herstellung einer Leuchtdiode aus dem Nitridhalbleiterprodukt der Fig. 1.

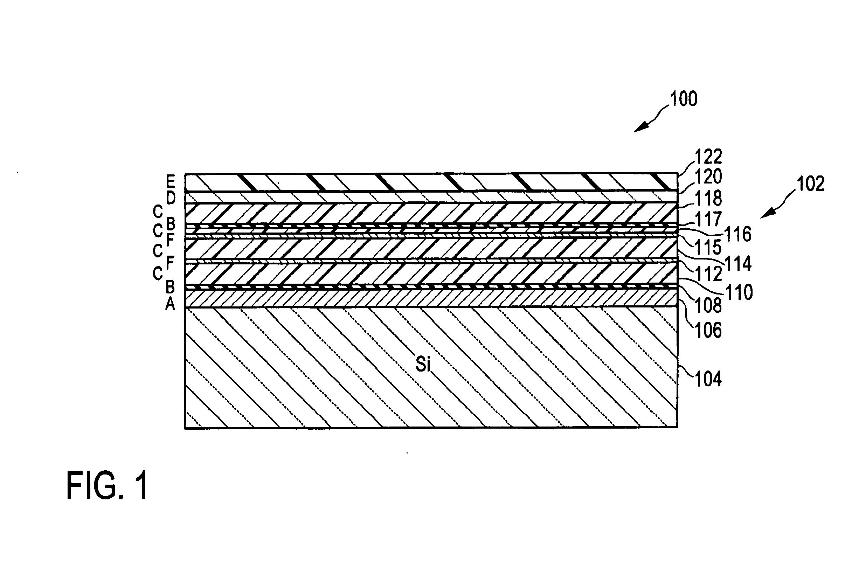

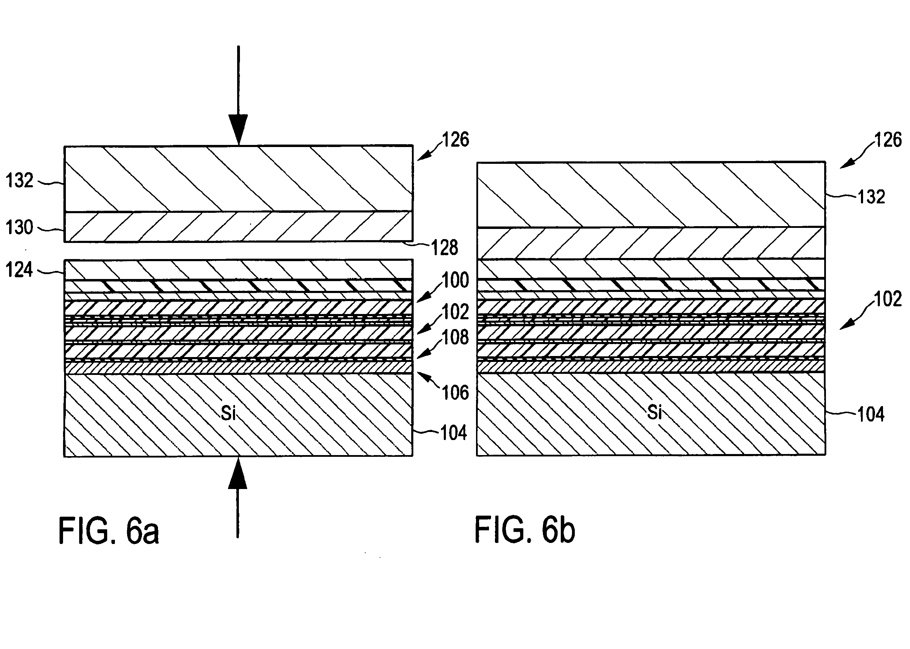

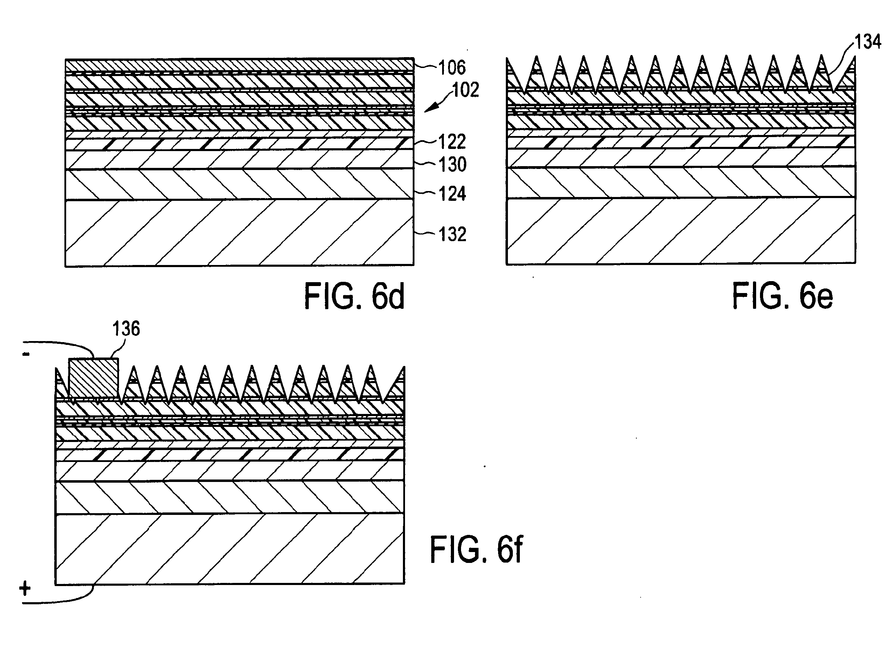

Fig. 1 zeigt in einer schematischen Ansicht den Schichtaufbau eines Nitridhalbleiterproduktes 100. Das Nitridhalbleiterprodukt 100 bildet ein Zwischenprodukt bei der Herstellung eines Nitridhalbleiterbauelements, wie weiter unten anhand der Fig. 6a) - 6f) näher erläutert wird.

Die Darstellung in Fig. 1 ist nicht maßstabsgetreu. Insbesondere lässt sich aus der Fig. nicht das genaue Verhältnis der Schichtdicken der einzelnen dargestellten Schichten zueinander bestimmen. Die in der Fig. gezeigten Schichtdickenverhältnisse geben insofern nur einen ganz groben Anhaltspunkt. Bei der nachfolgenden Beschreibung werden der Knappheit der Darstellung halber Verfahrensaspekte parallel zu Vorrichtungsaspekten erläutert.

Das Nitridhalbleiterprodukt 100 enthält eine Schichtstruktur 102 auf einem Siliziumwafer 104. Die verwendete Wachstumsoberfläche des Wafers, die senkrecht zur Papierebene der Fig. 1 steht, ist eine (111)-Siliziumoberfläche. Anstelle eines Siliziumwafers kann auch ein SOI-Substrat oder ein beliebiges anderes Substrat, vorzugsweise mit einer (111)-Siliziumoberfläche, verwendet werden.

In Fig. 1 sind zur Bezeichnung der Schichten der Deutlichkeit halber zusätzlich zu den von Zahlen gebildeten Bezugszeichen 106 bis 122 Buchstaben A bis F links neben die einzelnen Schichten gestellt. Dabei kennzeichnen gleiche Buchstaben Schichten gleichen Typs. Im einzelnen kennzeichnen

A eine Nitridankeimschicht im Verbund mit einer Pufferschicht,
B eine Maskierungsschicht,
C Nitridhalbleiterschichten, hier insbesondere n-leitende GaN-Schichten
D eine Multi-Quantum-Well-Struktur,
E eine p-dotierte Nitridhalbleiterdeckschicht, hier insbesondere p-GaN und
F eine Niedertemperatur-AIN oder AIGaN-Zwischenschicht für das Strain-Engineering.

Nähere Einzelheiten der Schichtstruktur und ihrer Herstellung werden nachfolgend beschrieben.

Vor dem Abscheiden von Schichten wird die Wachstumsoberfläche des Wafers 104 passiviert. Das bedeutet, dass sie entweder durch nasschemische Behandlung oder durch Ausheizen im Vakuum oder unter Wasserstoff bei Temperaturen oberhalb von 1.000 °C deoxidiert wird und eine Wasserstoff-terminierte Oberfläche erzeugt wird.

Die Ankeimschicht 106 hat eine Dicke von zwischen 10 und 50 nm. Im Verbund mit einer im vorliegenden Beispiel darauf abgeschiedenen, in der Verfahrensführung grundsätzlich jedoch optionalen Pufferschicht, entsteht eine Schichtdicke von maximal 400 nm.

Geeignet ist eine AIN-Keimschicht, die entweder bei niedriger Temperatur, also unterhalb von 1.000 °C, beispielsweise 600 - 800 °C oder bei hoher Temperatur, also gewöhnlichen Wachstumstemperaturen von

AlN oberhalb von 1.000 °C, gewachsen wird. Die optionale Pufferschicht ist vorzugsweise ebenfalls aus AlN und wird bei hohen Wachstumstemperaturen aufgebracht. Die Pufferschicht kann jedoch auch aus AlGaN bestehen. Bei Verwendung von AlGaN kann die Ankeimschicht auch eine größere Dicke aufweisen, beispielsweise ca. 600 nm.

Beim Wachstum der Keimschicht ist es günstig, die Zufuhr des Aluminiumprecursors in den Reaktor vor der Zufuhr des Stickstoffprecursors zu starten, um so eine Nitridierung des Substrats zu verhindern. Eine Nitridierung des Substrats kann zu einem unerwünschten polykristallinen Wachstum von AlN führen.

Auf dem Verbund von Ankeim- und Pufferschicht 106 wird eine Maskierungsschicht aus Siliziumnitrid abgeschieden. Dies erfolgt durch gleichzeitiges Leiten eines Siliziumprecursors wie beispielsweise Silan oder Disilan oder einer organischen Silizium-Verbindung, und eines Stickstoffprecursors wie Ammoniak oder Dimethylhydrazin. Auf der Wachstumsoberfläche reagieren die beiden Precursor unter Bildung von Siliziumnitrid.

Die Dicke der SiN-Maskierungsschicht wird so gewählt, dass beim nachfolgenden Wachstum der ersten Nitridhalbleiterschicht 110 in einer mitlaufenden Reflektometriemessung bei einer Wellenlänge von 630 nm die volle Oszillationsstärke erst nach mehr als vier Oszillationen erreicht ist. Dies entspricht ca. 600 nm Schichtdicke. Im Allgemeinen führt dies zu einer Oberfläche mit einer nur geringen Löcherdichte, d.h. noch nicht planarisierten Bereichen zwischen den ursprünglichen Inseln, von < 5%, die in der Reflektometrie in der Regel nicht auflösbar ist. Eine geeignete SiN-Schichtdicke ist nach dieser Vorschrift durch einfache Versuche zu ermitteln. Eine Übertragung dieser technischen Lehre auf andere bei der Reflektometrie verwendete Wellenlängen ist für den Fachmann problemlos.

Beim Wachstum der ersten Nitridhalbleiterschicht 110, die im vorliegenden Beispiel der Fig. 1 im wesentlichen aus GaN besteht und deshalb auch als GaN-Schicht 110 bezeichnet wird, werden im vorliegenden Ausführungsbeispiel keine Koaleszenz fördernde Wachstumsparameter eingestellt. Das heißt, die Temperatur und das Verhältnis von Stickstoff- und Galliumprecursor werden nicht erhöht. Unter Verwendung solcher Parameter erhält man ein ausreichend kompressives Wachstum der GaN-Schicht 110 und damit einen weit geringeren tensilen Stress nach dem Abkühlen, und somit eine wesentlich weniger gekrümmte und homogene entspannte Bauelementstruktur.

Die genannten Wachstumsbedingungen führen zu einer höheren Inselgröße, die eine Verbesserung der Schichtqualität bewirkt und ebenfalls eine geringere Risstendenz zeigt.

Die Schichtdicke der GaN-Schicht 110 beträgt zwischen 800 und 1600 nm. Hierauf wird für das Strain-Engineering eine aluminiumhaltige Nitridhalbleiterzwischenschicht in Form einer Niedertemperatur-AlN-Zwischenschicht 112 abgeschieden. Die Niedertemperatur-AlN-Zwischenschicht hat hier eine Dicke von 8 bis 15 nm.

Die Niedertemperatur-AlN-Zwischenschicht erhöht die kompressive Stresskomponente. Würde diese Schicht weggelassen, könnte aufgrund der SiN-Maskierungsschicht 108 eine GaN-Schicht von 1300 nm Dicke rissfrei gewachsen werden, weil beim Abkühlen in diesem Fall die tensile Stresskomponente oberhalb dieser Dicke Risse hervorrufen würde.

Das Einfügen der Niedertemperatur-AlN-Zwischenschicht 112 erlaubt es also, eine höhere Gesamtschichtdicke der GaN-Schicht durch Aufwachsen einer Abfolge weiterer GaN-Schichten und Niedertemperatur-AlN-Zwischenschichten zu erzielen. Der Niedertemperatur-AlN-Zwischenschicht 112 folgt dementsprechend eine zweite GaN-Schicht 114 von erneut ca. 800 bis 1600 nm Dicke, wiederum gefolgt von einer weiteren Niedertemperatur-AlN-Zwischenschicht 115. Auf dieser wird eine dritte GaN-Schicht 116 abgeschieden. Auf dieser wiederum wird eine zweite Maskierungsschicht 117 aus SiN abgeschieden. Die zweite SiN-Maskierungsschicht 117 bewirkt eine Reduzierung der Versetzungsdichte in der nachfolgenden vierten GaN-Schicht 118. Die vier GaN-Schichten 110, 114, 116 und 118 sind n-dotiert. Die Dotierung erfolgt beim Wachstum durch Zugabe eines geeigneten Dotierstoffprecursors.

Die soweit beschriebene Verfahrensführung führt also schon in der ersten GaN-Schicht 110, die der ersten Nitridhalbleiterschicht der oben stehenden Beschreibung entspricht, zu einem Wachstum mit kompressivem Stress. Die so erzielbare verringerte tensile Verspannung erleichtert das spätere Entfernen und Aufkleben des Wafers 104 auf einen Träger. Denn die auf den Kleber wirkenden Kräfte sind geringer. Die gesamte Schichtstruktur 102 bleibt demnach einfacher auf dem Träger hängen. Die verbesserte Kristallstruktur und die reduzierte tensile Verspannung schon in der ersten GaN-Schicht 110 reduzieren darüber hinaus die Neigung zur Rissbildung während und nach dem Ablösen der Schichtstruktur 102.

Auf der vierten GaN-Schicht 118 wird eine Multi-Quantum-Well-Struktur abgeschieden. Die Materialwahl und genaue Schichtstruktur dieser Multi-Quantum-Well-Struktur 120 wird entsprechend der gewünschten Wellenlänge der Lichtemission eingestellt. Die hierfür einzustellenden Parameter, wie Schichtstöchiometrie und Schichtdicke sind dem Fachmann bekannt. Bekanntermaßen wird durch Zugabe von Indium die Bandlücke eines Nitridhalbleiters, beispielsweise ausgehend von reinem GaN, in Richtung der Bandlücke von Indiumnitrid reduziert. Durch Zugabe von Aluminium wird die Bandlücke in Richtung des Wertes von AlN erhöht. Auf diese Weise kann eine Lichtemission mit einer gewünschten Wellenlänge eingestellt werden, die zwischen dem roten und dem ultravioletten Spektralbereich liegt.

Auf der Multi-Quantum-Well-Struktur 120 kann optional eine Injektionsbarriere von etwa 10 bis 30 nm Dicke vorgesehen sein, die in Fig. 1 nicht dargestellt ist.

Dargestellt ist vielmehr eine unmittelbar an die Multi-Quantum-Well-Struktur 120 anschließende Deckschicht 122 aus p-GaN.

Die vorstehende Beschreibung betraf ein Ausführungsbeispiel eines erfindungsgemäßen Nitridhalbleiterbauelements. Es versteht sich, dass bei einem anderen Bauelement wie beispielsweise einem Feldeffekttransistor die Einzelheiten des Schichtaufbaus und der Schichtdotierung in an sich bekannter Weise einzustellen sind.

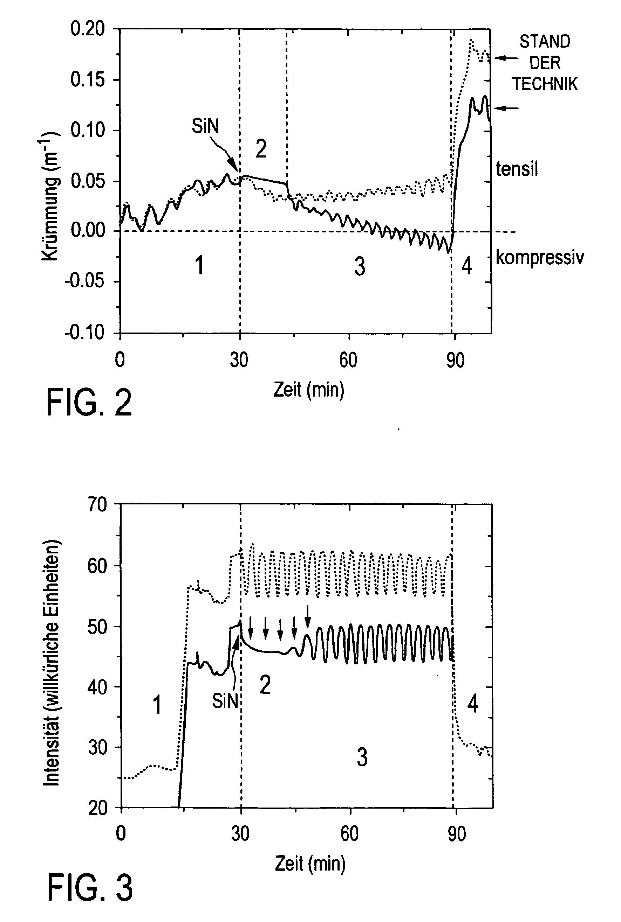

Fig. 2 zeigt ein Diagramm, das die Entwicklung der Krümmung eines Nitridhalbleiterprodukts während seiner Herstellung nach dem erfindungsgemäßen Verfahren darstellt, sowie im Vergleich die Krümmung eines Nitridhalbleiterprodukts nach dem Stand der Technik während seiner Herstellung. Auf der Abszisse des Diagramms ist die Zeit in Minuten abgetragen, die zwischen dem Beginn der Schichtabscheidung auf einem (111)-Siliziumsubstrat und dem Ende des Abkühlens der gewachsenen Schichtstruktur verstreicht. Auf der Ordinate ist die Krümmung aufgetragen, also der Kehrwert des Krümmungsradius des Nitridhalbleiterprodukts. Die Messung der Krümmung ist mit modernen Messmethoden in großer Präzision möglich. Details der Krümmungsmessung können den Veröffentlichungen A. Krost et al., phys. stat. sol. (b) 242, 2570-2574 (2005) und A. Krost et al., phys. stat. sol. (a) 200, 26-35 (2003) entnommen werden. Die auf der Ordinate abgetragenen Krümmungswerte zwischen -0,2 und 0,2 entsprechen Krümmungen mit einem Betrag des Krümmungsradius zwischen 5m und Unendlich.

Im Diagramm der Fig. 2 sind zwei unterschiedliche Messkurven aufgetragen. Mit gestrichelten Linien ist eine Messkurve der Krümmung während des Wachstums des konventionellen Nitridhalbleiter nach dem Stand der Technik wiedergegeben. Mit durchgezogener Linie ist der zeitliche Verlauf der Krümmung des erfindungsgemäßen Nitridhalbleiterprodukts wiedergegeben.

Es lassen sich bei der erfindungsgemäßen Verfahrensführung vier unterschiedliche Wachstumsphasen unterscheiden, die in Fig. 2 durch vertikale gestrichelte Linien voneinander getrennt sind. Die so definierten Zeitintervalle sind mit arabischen Ziffern 1 bis 4 gekennzeichnet. In einem Zeitintervall 1 erfolgt das Wachstum der AIN-Ankeimschicht 106 sowie das Aufheizen auf eine zum Abscheiden von GaN geeignete Wachstumstemperatur oberhalb von 1000°C. Ausgehend von einer zunächst verschwindenden Krümmung (entsprechend einem unendlichem Krümmungsradius) stellt sich in diesem Zeitintervall bei beiden unterschiedlichen Strukturen eine geringfügige positive Krümmung ein. In einem anschließenden Zeitintervall 2, das sich von knapp über 30 Minuten bis etwa 45 Minuten nach Beginn des Wachstums erstreckt, wird die SiN-Maskierungsschicht (108 beim Beispiel der Fig. 1) und die erste GaN-Schicht (110 in Fig. 1) aufgewachsen. In dieses Zeitintervall fällt der Beginn der Koaleszenz der GaN-Wachstumsinseln. Deutlich erkennbar ist, dass die Krümmung der nach dem erfindungsgemäßen Verfahren hergestellten Schichtstruktur in diesem Stadium höhere Werte annimmt als in der Vergleichsstruktur, die mit einem konventionellen Verfahren ohne SiN-Maskierungsschicht gewachsen wird.

In einem nachfolgenden Zeitintervall 3 wird die erste GaN-Schicht (110 in Fig. 1) gewachsen. Bei der Vergleichsprobe nach konventionaller Verfahrensführung ist die Verfahrensführung hier wegen des Fehlens von Zwischenschichten abweichend und erstreckt sich das Zeitintervall 3 zwischen 30 und etwas über 80 Minuten nach Beginn des Wachstums. Vorliegend wird keine Niedertemperatur-AIN-Wachstumsphase zur Herstellung der AIN-Zwischenschicht 112 eingeschoben.

Beide Strukturen werden nach Abschluss der Schichtabscheidung abgekühlt (Zeitintervall 4). Bei der nach dem Stand der Technik hergestellten Vergleichsprobe wie bei der erfindungsgemäß hergestellten Probe erfolgt die Abkühlung etwa 90 Minuten nach Beginn des Verfahrens und führt bei der Vergleichsprobe im Ergebnis zu einer relativ starken Krümmung der Probe von etwa 0,17 m$^{-1}$, was einem Krümmungsradius von etwa 5,8m entspricht. Bei der erfindungsgemäß hergestellten Schichtstruktur beträgt die Krümmung nach Abschluss des Abkühlungsprozesses etwa 0,12 m$^{-1}$, was einem Krümmungsradius von etwa 8,3 m entspricht. Dieser Wert kann durch Einschieben weiterer Niedertemperatur AIN-Schichten, wie bei der Schichtstruktur der Fig. 1, weiter optimiert werden, so dass ein Nitridhalbleiterprodukt mit verschwindender Krümmung hergestellt werden kann.

Fig. 3 zeigt ein Diagramm mit der zeitlichen Entwicklung des von der Wachstumsoberfläche des Nitridhalbleiterprodukts während seiner Herstellung reflektierten Lichts während der anhand von Figur 2 beschriebenen Verfahrensführung für die Vergleichsprobe (gestrichelte Kurve) und die erfindungsgemäß hergestellte Probe. Das Diagramm zeigt also das Ergebnis einer Reflektometriemessung mit einer Lichtwellenlänge von ca. 600nm während des Wachstums der Schichtstruktur entsprechend der bei Fig. 2 erläuterten Prozessführung. Aufgetragen ist die reflektierte Lichtintensität über der Zeit. Das Diagramm ist in gleicher Weise wie Fig. 2 in Zeitabschnitte 1, 2, 3 und 4 unterteilt. Mit Pfeilen sind im Abschnitt 2 anfängliche Intensitätsmaxima der beim Schichtwachstum bekanntlich oszillierenden reflektierten Lichtintensität gekennzeichnet. Es ist erkennbar, dass im Unterschied zur Vergleichsprobe bei der erfindungsgemäß hergestellten Probe der volle Hub zwischen Intensitätsminima und -maxima nach 5 bis 6 Oszillationen erreicht ist. Wird die Dauer des Wachstums der Maskierungsschicht so eingestellt, dass ein derartiger Verlauf in der Reflektometriemessung auftritt, liegen erfahrungsgemäß im Abscheideschritt der GaN-Schicht zunächst getrennte Kristallite vor, die oberhalb einer Koaleszenzschichtdicke zusammenwachsen und in einer Schichtebene der zusammengewachsenen Nitridhalbleiterschicht senkrecht zur Wachstumsrichtung eine durchschnittliche Fläche von 0,16 $\mu$m$^2$ bis 0,36 $\mu$m$^2$ einnehmen. Es ist zu erwarten, dass bei weiterer Optimierung der Wachstumsparameter noch größere durchschnittliche Flächen erzielt werden können.

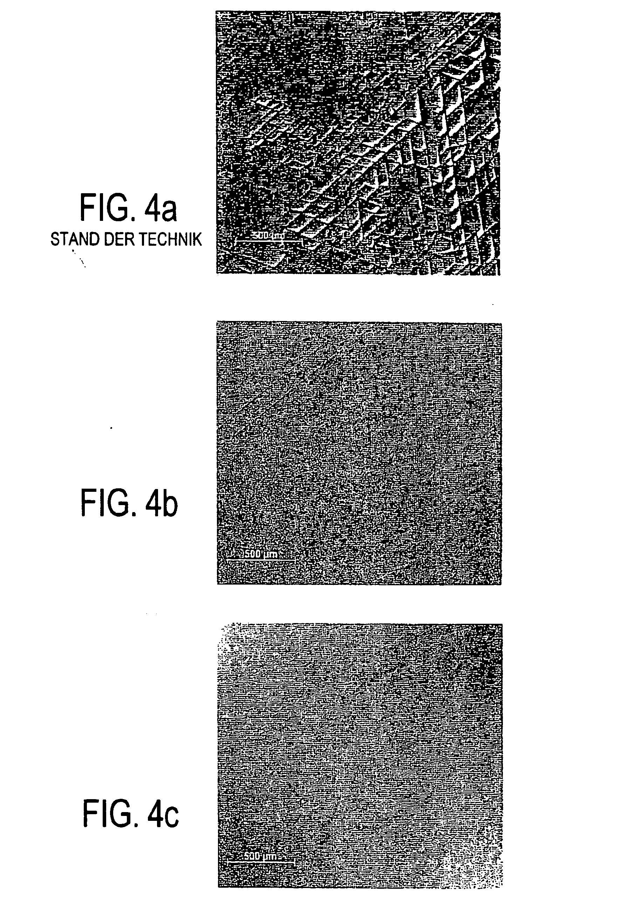

Fig. 4a) und b) zeigen Differenz-Interferenzkontrastmikroskop(DIC)-Aufnahmen von GaN-Schichten, die mit Verfahren gemäß dem Stand der Technik hergestellt wurden. Fig. 4c) zeigt eine eine DIC-Aufnahme einer GaN-Schicht, die mit einem Verfahren gemäß dem Stand der Technik hergestellt wurde.

Die rasterelektronenmikroskopischen Aufnahmen der Fig. 4a) bis 4c) zeigen mit gleichem Maßstab abgebildete Oberflächen unterschiedlich hergestellter GaN-Schichten. Die in Fig. 4a) dargestellte Probe wurde ohne SiN-Maskierungsschicht hergestellt und hat eine Dicke von etwa 2,5 $\mu$m. Deutlich zu erkennen ist, dass die Oberfläche eine Vielzahl von Rissen aufweist. Die in Fig. 4b) dargestellte Oberfläche gehört zu einer Probe, die zwar mit einer SiN-Maskierungsschicht, jedoch ohne AIN-Zwischenschicht zum Strain-Engineering mit einer Dicke von 2,4 $\mu$m hergestellt wurde. Diese Schicht zeigt eine gegenüber der zuvor erläuterten Probe deutlich verbesserte Struktur mit nur wenigen Rissen.

Die in Fig. 4c) dargestellte Oberfläche einer Probe, die erfindungsgemäß, also mit einer geeigneten SiN-Maskierungsschicht und mit Niedertemperatur-AIN-Zwischenschichten bis zu einer Dicke von 2,8 $\mu$m gewachsen wurde, zeigt dagegen eine stark verbesserte Qualität ohne jegliche Rissbildung im abgebildeten Ausschnitt.

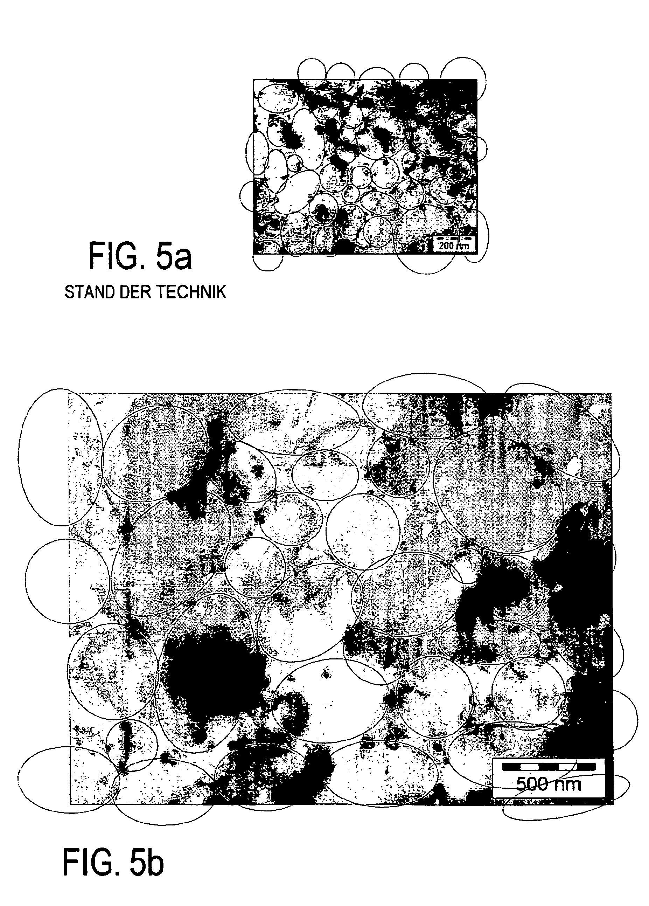

Fig. 5a) zeigt eine In-Plane-Transmissionelektronenmikroskopie-Aufnahme einer GaN-Schicht, die mit einem Verfahren nach dem Stand der Technik hergestellt wurde. Fig. 5b) zeigt eine In-Plain-Transmissionelektronenmikroskopische-Aufnahme einer GaN-Schicht, die mit einem erfindungsgemäßen Verfahren hergestellt wurde. Die Aufnahmen zeigen mit etwa gleichem Maßstab unterschiedlich gewachsene GaN-Schichten. Beim Wachstum der in Fig. 5a) abgebildeten Schicht wurde keine SiN-Maskierungsschicht verwendet. Beim Wachstum der in Fig. 5b) abgebildeten Schicht wurde dagegen die erfindungsgemäße Prozessfolge eingehalten.

Zur Auswertung der Aufnahmen wurde die Größe der in der abgebildeten Schichtebene sichtbaren Kristalliten geschätzt, und hierfür wurden der Aufnahme kreisförmige oder elliptische Ringe überlagert, die in etwa der erkennbaren Grenze der zusammengewachsenen Kristallite folgen.

Zur Erläuterung wird hinzugefügt, dass Versetzungen in der Heteroepitaxie zum einen als Anpassungsversetzungen an der Grenzfläche und zum anderen durch das zumeist stattfindende Inselwachstum entstehen. Inseln wachsen bei starker Fehlanpassung der Kristallstrukturen immer leicht verkippt (tilt) oder verdreht (twist) auf. Dabei verursacht die Verkippung an der Grenzfläche von zwei Kristalliten die Entstehung von Schraubenversetzungen. Die Verdrehung verursacht an der Grenzfläche zweier Kristalliten die Entstehung von Stufenversetzungen. Diese Versetzungen entstehen demnach an der Grenze von zwei Kristallisten eben durch den mit zunehmender Schichtdicke eintretenden Koaleszenzprozess. Nur wenige Versetzungen kommen unabhängig von diesen Effekten zustande, etwa unmittelbar von der Grenzfläche zum Substrat her. Daher geben die erkennbaren Stufen- und Schraubenversetzungen in etwa die Grenze der zusammenwachsenden Kristallite an, weil sie, sofern der Nachbarkristallit leicht fehlorientiert ist, diesen dekorieren. Zur Überprüfung der durchschnittlichen Fläche der Kristallite sollte eine Schichtebene in einem Abstand von 700 $\pm$ 50 nm von der Maskierungsschicht herangezogen werden.

Aus dem Verhältnis der abgebildeten Fläche und der Anzahl der so identifizierten Kristallite wurde eine durchschnittliche Fläche ermittelt, die die Kristallite in der dargestellten Schnittebene einnehmen. Diese Schnitteebene liegt in beiden untersuchten Proben oberhalb der Koaleszenzschichtdicke. Bei der in Fig. 5a) dargestellten Probe wurden auf einer Fläche von 894 nm x 1195 nm = 1,0681 $\mu$m$^2$ 38 Kristallite gezählt. Dies ergibt eine durchschnittliche Fläche von 0,0281 $\mu$m$^2$ pro Kristallit.

Bei der in Fig. 5b) dargestellten Probe eines erfindungsgemäßen Nitridhalbleiterproduktes wurden dagegen auf einer Fläche 2982 nm x 2238 nm = 6,67 $\mu$m$^2$ 35 Kristallite gezählt. Dies ergibt eine durchschnittliche Fläche von 0,19 $\mu$m$^2$ pro Kristallit.

Anzumerken ist, dass die untersuchte Probe der Fig. 5b) in ihrer Qualität am unteren Rand der mit dem erfindungsgemäßen Verfahren erzielbaren Werte liegt. Vorzugsweise erfolgt die Verfahrensführung so, dass die durchschnittliche Fläche mindestens 0,36 $\mu$m$^2$ beträgt. Auf diese Weise kann der kompressive Stress in der GaN-Schicht deutlich erhöht werden, was zu besseren Ergebnissen des Krümmungsradius und des tensilen Stress in dem fertigen Bauelement führt.

Fig. 6a) - 6f) zeigen unterschiedliche Verfahrensstadien bei der Herstellung einer Leuchtdiode aus dem Nitridhalbleiterprodukt der Fig. 1. Die hier beschriebene Verfahrensführung schließt sich an die Herstellung des Nitridhalbleiterbauelements der Fig. 1 an.

Dabei wird auf dem Nitridhalbleiterprodukt 100 zunächst eine Oberseitenmetallisierung versehen. Diese dient einerseits zum nachfolgenden Bonden an einen Träger 126 und andererseits zur Verbesserung der Lichtauskopplung aus dem entstehenden Bauelement.

Der Träger 126 ist aus Kupfer oder AlSi gefertigt und hat an einer Seite 128, die zum Bonden verwendet wird, eine Metallisierung 130. Fig. 6b) zeigt ein Prozessstadium nach dem Bonden. Das Bonden wird bei einer Temperatur von 280 °C durchgeführt. Das Verwenden einer derart niedrigen Temperatur hat den Vorteil, dass keine zusätzlichen Verspannungen durch den thermischen Zyklus beim Bonden entstehen.

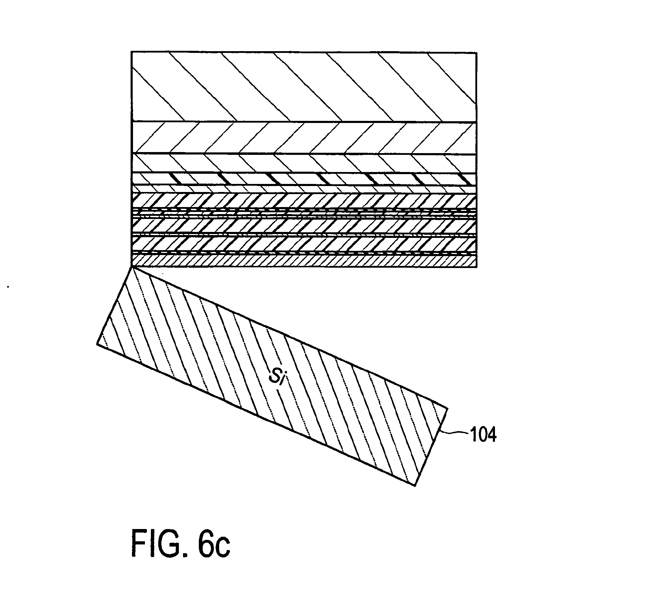

In einem nachfolgenden Schritt wird der Si-Wafer 104 entfernt. Dies ist in Fig. 6c) schematisch dargestellt. Der Si-Wafer 104 wird mittels Schleifen und Ätzen entfernt. Das Ätzen kann nass- oder trockenchemisch erfolgen. Es entsteht so die in Fig. 6d) dargestellte Struktur, bei der die ehemals mit dem Si-Wafer verbundene Ankeimschicht 106 nun die Oberseite bildet und die p-Deckschicht 122 unmittelbar an die Metallisierung 124/130 anknüpft. In einem nachfolgenden Schritt wird die Oberseite durch Ätzen strukturiert. Durch das Ätzen, beispielsweise mit KOH oder $H_3PO_4$ entstehen pyramidenförmige Strukturen, die die Lichtauskopplung aus dem Bauelement verbessern. Abschließend werden Kontaktstrukturen erzeugt. Für eine Flusspolung der Leuchtdiode wird ein negativ zu polender Kontakt 136 auf der Oberfläche und ein positiv zu polender Kontakt am Träger vorgesehen.

Das Schichtwachstum ist erfindungsgemäß auf großen Substraten möglich und erlaubt so entweder die Herstellung großer Bauelemente oder eine kosteneffiziente Herstellung einer großen Anzahl kleinerer Bauelemente. Die beschriebene Prozessführung kommt ohne das bei der Verwendung von Saphir-Substraten übliche Laser-Ablösen aus und ist daher einfacher und billiger. Lediglich für die Herstellung von Rückseitenkontakt und eine Strukturierung vor der Vereinzelung der Bauelemente sind Fotolithographieschritte erforderlich.

Die vorstehende Beschreibung zeigt, dass auf der Grundlage des erfindungsgemäßen Wachstumsverfahrens für eine unverspannte Nitridhalbleiterschichtstruktur eine besonders einfache Prozessierung in der weiteren Bauelementherstellung möglich ist. Auf diese Weise können qualitativ hochwertige, jedoch kostengünstige Bauelemente hergestellt werden.

Bei der Verfahrensführung sind verschiedene Varianten möglich. Beispielsweise kann die p-leitfähige Deckschicht 122 nach mindestens 20 nm Wachstum von p-GaN mit einer SiN-Maske versehen werden. Das anschließende weitere Wachstum von p-GaN erfolgt inselförmig und führt nicht zur vollständigen Koaleszenz. Dies erzeugt eine raue Oberfläche und führt bei dem fertigen Halbleiterbauelement der Fig. 6f) zu einer homogeneren Lichtabstrahlung nach oben. Das Licht wird besser ausgekoppelt, selbst wenn auf der Oberseite eine weniger effiziente Antireflexschicht aufgebracht wird.

**Patentansprüche**

1. Verfahren zur Herstellung einer Schichtstruktur (102) eines Nitridhalbleiterbauelements auf einer Siliziumoberfläche, mit den Schritten:

   - Bereitstellen eines Substrats (104), das eine Siliziumoberfläche hat;
   - Abscheiden einer aluminiumhaltigen Nitridankeimschicht (106) auf der Siliziumoberfläche des Substrats (104);
   - Optional: Abscheiden einer aluminiumhaltigen Nitridpufferschicht ( A) auf der Nitridankeimschicht;

   - Abscheiden einer Maskierungsschicht (108, B) auf der Nitridankeimschicht oder, wenn vorhanden, auf der ersten Nitridpufferschicht;
   - Abscheiden einer galliumhaltigen ersten Nitridhalbleiterschicht (110) auf der Maskierungsschicht, bei dem
   - die erste Nitridhalbleiterschicht als kompressiv verspannte Schicht auf der Maskierungsschicht abgeschieden wird,

   **dadurch gekennzeichnet, dass**

   - die Maskierungsschicht derart abgeschieden wird, dass im Abscheidschritt der ersten Nitridhalbleiterschicht (110) zunächst getrennte Kristallite wachsen, die oberhalb einer Koaleszenzschichtdicke zusammenwachsen und in einer Schichtebene der zusammengewachsenen Nitridhalbleiterschicht (110) senkrecht zur Wachstumsrichtung pro Kristallit eine durchschnittliche Fläche von 0,16 $\mu m^2$ bis 0,36 $\mu m^2$ einnehmen,
   - und dass die Maskierungsschicht (108, B) mit einer Schichtdicke abgeschieden wird, die bei der zunächst in Form der getrennten Kristallite aufwachsenden ersten Nitridhalbleiterschicht frühestens ab einem Abstand von durchschnittlich mindestens 600 nm von der Maskierungsschicht eine mehr als 95 % geschlossene Schichtfläche entstehen lässt,
   - und dass die galliumhaltige erste Nitridhalbleiterschicht (110) auf der Maskierungsschicht ohne Verwendung Koaleszenz fördernder Wachstumsparameter abgeschieden wird.

2. Verfahren nach Anspruch 1, bei dem die Maskierungsschicht (108, B) mit einer Bedeckung der darunter liegenden Nitridankeimschicht (106) oder, wenn vorhanden, der ersten Nitridpufferschicht von mindestens 95 % abgeschieden wird.

3. Verfahren nach Anspruch 1 oder 2, bei dem die Maskierungsschicht (108, B) aus Siliziumnitrid abgeschieden wird.

4. Verfahren nach einem der vorstehenden Ansprüche, bei dem die Dauer der Abscheidung der Maskierungsschicht so gewählt wird, dass beim Abscheideschritt der ersten Nitridhalbleiterschicht (110) eine mitlaufende Messung der Reflexionsintensität der Wachstumsoberfläche mit einer Lichtwellenlänge von ca. 600nm einen oszillierenden Intensitätsverlauf mit ansteigender Oszillationsamplitude zeigt, die nach mindestens 5 Oszillationszyklen einen dann etwa gleichbleibenden Maximalwert erreicht.

5. Verfahren nach einem der vorstehenden Ansprüche, bei dem das Abscheiden der Nitridankeimschicht (106) auf einer (111)-Siliziumoberfläche erfolgt.

**6.** Verfahren nach einem der vorstehenden Ansprüche, bei dem die erste Nitridhalbleiterschicht (110) mit einer Schichtdicke von zwischen 800 nm und 1600 nm abgeschieden wird.

**7.** Verfahren nach Anspruch 6, bei dem auf der ersten Nitridhalbleiterschicht eine aluminiumhaltige Nitridzwischenschicht (112) abgeschieden wird und bei dem auf letzterer Schicht eine galliumhaltige weitere, zweite Nitridhalbleiterschicht (114) abgeschieden wird.

**8.** Verfahren nach Anspruch 7, bei dem die Schrittfolge der Abscheidung einer aluminiumhaltigen Nitridzwischenschicht und einer galliumhaltigen weiteren Nitridhalbleiterschicht (114) wiederholt durchgeführt wird.

**9.** Verfahren nach Anspruch 7 oder 8, bei dem auf der weiteren Nitridhalbleiterschicht eine Multi-Quantum-Well-Struktur (120) aus Nitridhalbleitermaterial abgeschieden wird.

**10.** Verfahren nach Anspruch 9, **gekennzeichnet durch** das Abscheiden mindestens einer weiteren Maskierungsschicht (117) aus Siliziumnitrid unmittelbar vor dem Abscheiden derjenigen der weiteren Nitridhalbleiterschichten, auf der die Multi-Quantum-Well-Struktur (120) abgeschieden wird.

**11.** Verfahren nach einem der vorstehenden Ansprüche, bei dem eine n-Dotierung in die erste (110) und, wenn vorhanden, diejenigen weiteren Nitridhalbleiterschichten (114) eingebracht wird, die vor der Multi-Quantum-Well-Struktur (120) abgeschieden werden.

**12.** Verfahren nach einem der vorstehenden Ansprüche, mit den Schritten: Herstellen einer p-dotierten, galliumhaltigen Nitridhalbleiterdeckschicht (122) auf der Multi-Quantum-Well-Struktur.

**13.** Verfahren nach einem der vorstehenden Ansprüche, bei dem der Schritt des Bereitstellens eines Substrats (104) das Bereitstellen eines Siliziumsubstrats beinhaltet, dessen Dicke mindestens $D_{GaN}{}^*x$ beträgt, wobei $D_{GaN}$ die Schichtdicke der auf dem Substrat abzuscheidenden Nitridhalbleiterschicht oder, wenn mehr als eine Nitridhalbleiterschicht abzuscheiden ist, die Summe der Schichtdicken der auf dem Substrat abzuscheidenden Nitridhalbleiterschichten und der vorhandenen Nitridzwischenschicht bezeichnet, und wobei x im Falle der Verwendung eines dotierten Siliziumsubstrats 110 und im Falle der Verwendung eines undotierten Substrats 200 beträgt.

**14.** Verfahren zur Herstellung eines Nitridhalbleiterbauelements, mit den Schritten:

- Herstellung einer Schichtstruktur (102) eines Nitrid-Halbleiterbauelements auf einer Siliziumoberfläche nach einem der vorstehenden Ansprüche;
- Bonden der Schichtstruktur mit einem Träger (126) derart, dass die Wachstumsoberseite der Schichtstruktur (102) dem Träger zugewandt ist;
- entweder vollständiges oder teilweises Entfernen des Substrats (104);
- Herstellung einer Kontaktstruktur.

**15.** Verfahren nach Anspruch 14, mit einem Schritt des Abscheidens einer elektrisch leitfähigen Kontaktschicht auf der Wachstumsoberseite der Schichtstruktur (102).

**16.** Verfahren nach Anspruch 15, bei dem für die Kontaktschicht (124, 130) ein Material verwendet wird, das einen höheren Brechungsindex hat als die p-dotierte Nitridhalbleiterdeckschicht.

**17.** Verfahren nach einem der Ansprüche 14 bis 16, mit einem vor dem Bonden durchgeführten Schritt des Metallisierens der Wachstumsoberseite der Schichtstruktur oder, wenn vorhanden, der Kontaktschicht.

**18.** Verfahren nach einem der Ansprüche 14 bis 17, bei dem ein Träger verwendet wird, dessen zum Bonden verwendete Oberfläche elektrisch leitfähig oder reflektierend oder metallisch ist.

**19.** Verfahren nach einem der Ansprüche 16 bis 18, bei dem die Nitridhalbleiterdeckschicht der Schichtstruktur mit einer Dicke von

$$m \cdot \frac{\lambda}{2 \cdot n_{Nirid}} + \frac{\lambda}{4 \cdot n_{Nirid}} - \frac{d_{MQW}}{2}$$

abgeschieden wird, wobei m = 0, 1, 2, 3, ...; λ eine Wellenlänge einer Lichtemission der Multi-Quantum-Well-Struktur im Betrieb des Nitrid-Halbleiterbauelements, $n_{Nitrid}$ den Brechungsindex des Nitrids bei der Wellenlänge λ und $d_{MQW}$ die Dicke der Multi-Quantum-Well-Struktur (120) bezeichnet.

**20.** Verfahren nach Anspruch 15, bei dem für die Kontaktschicht (124, 130) ein Material verwendet wird, das einen geringeren Brechungsindex hat als die p-dotierte Nitridhalbleiterdeckschicht.

**21.** Verfahren nach Anspruch 20, bei dem die Nitridhalbleiterdeckschicht der Schichtstruktur mit einer Dicke

von $m \cdot \dfrac{\lambda}{2 \cdot n_{Nitrid}} - \dfrac{d_{MQW}}{2}$ abgeschieden wird, wobei m = 1, 2, 3, 4, ...; λ, eine Wellenlänge einer Lichtemission der Multi-Quantum-Well-Struktur im Betrieb des Nitrid-Halbleiterbauelements, $n_{Nitrid}$ den Brechungsindex des Nitrids bei der Wellenlänge λ und $d_{MQW}$ die Dicke der Multi-Quantum-Well-Struktur (120) bezeichnet.

22. Verfahren nach einem der Ansprüche 14 bis 21, bei dem das Bonden bei einer Temperatur im Bereich zwischen 280 und 500 °C erfolgt.

23. Verfahren nach einem der Ansprüche 14 bis 22, bei dem der Schritt des Entfernens des Substrats (104) durch Abschleifen oder durch kombiniertes Abschleifen und Ätzen erfolgt.

24. Verfahren nach einem der Ansprüche 14 bis 22, bei dem der Schritt des Entfernens des Substrats (104) allein durch Ätzen erfolgt.

25. Verfahren nach einem der Ansprüche 14 bis 23, bei dem die durch Entfernen des Substrats freigelegte Wachstumsrückseite zur Bildung einer antireflexiv wirkenden Schicht strukturiert wird.

26. Nitridhalbleiterbauelement mit einer Schichtstruktur (102) enthaltend

    - eine galliumhaltige erste Nitridhalbleiterschicht (110), die eine Struktur zusammengewachsener Kristallite aufweist, die in einer Schichtebene senkrecht zur Wachstumsrichtung pro Kristallit eine durchschnittliche Fläche von zwischen 0,16 $\mu m^2$ und 0,36 $\mu m^2$ einnehmen,
    - eine aluminiumhaltige Nitridzwischenschicht (112), die an die erste Nitridhalbleiterschicht (110) angrenzt, und,
    - angrenzend an letztere Schicht, eine galliumhaltige weitere, zweite Nitridhalbleiterschicht (114), wobei die Schichtstruktur auf einem Träger derart gebondet ist, dass die zweite Nitridhalbleiterschicht dem Träger zugewandt angeordnet ist und wobei die Kristallite der galliumhaltigen ersten Nitridhalbleiterschicht (110) frühestens ab einem Abstand von 600 nm von derjenigen Grenzfläche der ersten Nitridhalbleiterschicht (110), die vom Träger (126) abgewandt ist, eine zu mehr als 95 % geschlossene Schichtfläche bildet.

27. Nitridhalbleiterbauelement nach Anspruch 26, bei dem die Kristallite in einer Schichtebene senkrecht zur Wachstumsrichtung eine durchschnittliche Ausdehnung von mindestens 400 x 400 $nm^2$ haben.

28. Nitridhalbleiterbauelement nach einem der Ansprüche 26 oder 27, bei dem die erste Nitridhalbleiterschicht (110) eine Schichtdicke von zwischen 800 nm und 1600 nm aufweist.

29. Nitridhalbleiterbauelement nach einem der Ansprüche 26 bis 28, das die Schichtfolge von aluminiumhaltiger Nitridzwischenschicht (112) und galliumhaltiger weiteren Nitridhalbleiterschicht (114) wiederholt enthält.

30. Nitridhalbleiterbauelement nach einem der Ansprüche 28 oder 29, bei dem auf der weiteren Nitridhalbleiterschicht (114) eine Multi-Quantum-Well-Struktur (120) aus Nitridhalbleitermaterial abgeschieden wird.

31. Nitridhalbleiterbauelement nach Anspruch 30, **gekennzeichnet durch** mindestens eine weitere Maskierungsschicht (117, B) aus Siliziumnitrid unmittelbar angrenzend an diejenige der weiteren Nitridhalbleiterschichten (118), auf der die Multi-Quantum-Well-Struktur (120) abgeschieden wird, jedoch an der von der Multi-Quantum-Well-Struktur (120) abgewandten Seite dieser weiteren Nitridhalbleiterschicht (118).

32. Nitridhalbleiterbauelement nach einem der Ansprüche 26 bis 31, bei der die erste (110) wenn vorhanden, diejenigen weiteren Nitridhalbleiterschichten (114, 116, 118) n-dotiert sind, die auf der Seite der Multi-Quantum-Well-Struktur (120) angeordnet sind, die der ersten Nitridhalbleiterschicht (110) zugewandt ist.

33. Nitridhalbleiterbauelement nach einem der Ansprüche 30 bis 32, mit einer p-dotierten, galliumhaltigen Nitridhalbleiterdeckschicht (122), die auf der, der ersten Nitridhalbleiterschicht (110) abgewandten Seite der Multi-Quantum-Well-Struktur (120), angeordnet ist.

34. Nitridhalbleiterbauelement nach einem der Ansprüche 26 bis 33, bei dem der Träger (126) und die zweite Nitridhalbleiterschicht über eine Metallschicht miteinander verbunden sind.

35. Nitridhalbleiterbauelement nach Anspruch 34, bei dem der Träger (126) im wesentlichen aus Kupfer oder Aluminium oder Silizium oder Aluminiumnitrid oder aus Al/Si besteht.

36. Nitridhalbleiterbauelement nach einem der Ansprüche 26 bis 35, bei dem zwischen dem Träger (126) und der zweiten Nitridhalbleiterschicht (114) eine elektrisch leitfähige Kontaktschicht angeordnet ist.

37. Nitridhalbleiterbauelement nach Anspruch 33 und Anspruch 36, bei dem die Kontaktschicht einen höheren Brechungsindex hat als die p-dotierte Nitridhalbleiterdeckschicht (122).

**38.** Nitridhalbleiterbauelement nach Anspruch 33, bei dem die Nitridhalbleiterdeckschicht der Schichtstruktur eine Dicke von

$$m \cdot \frac{\lambda}{2 \cdot n_{Nirid}} + \frac{\lambda}{4 \cdot n_{Nirid}} - \frac{d_{MQW}}{2} \text{ abgeschie-}$$

den wird, wobei m = 0, 1, 2, 3, ...; $\lambda$ eine Wellenlänge einer Lichtemission der Multi-Quantum-Well-Struktur (120) im Betrieb des Nitrid-Halbleiterbauelements, $n_{Nitrid}$ den Brechungsindex des Nitrids bei der Wellenlänge $\lambda$ und $d_{MQW}$ die Dicke der Multi-Quantum-Well-Struktur (120) bezeichnet.

**39.** Nitridhalbleiterbauelement nach Anspruch 33 und Anspruch 36, bei dem die Kontaktschicht einen geringeren Brechungsindex hat als die p-dotierte Nitridhalbleiterdeckschicht (122).

**40.** Nitridhalbleiterbauelement nach Anspruch 39, bei dem die Nitridhalbleiterdeckschicht der Schichtstruktur eine Dicke von $m \cdot \dfrac{\lambda}{2 \cdot n_{Nitrid}} - \dfrac{d_{MQW}}{2}$

wobei m = 1, 2, 3, 4, ...; $\lambda$ eine Wellenlänge einer Lichtemission der Multi-Quantum-Well-Struktur (120) im Betrieb des Nitrid-Halbleiterbauelements, $n_{Nitrid}$ den Brechungsindex des Nitrids bei der Wellenlänge $\lambda$ und $d_{MQW}$ die Dicke der Multi-Quantum-Well-Struktur (120) bezeichnet.

**41.** Nitridhalbleiterbauelement nach einem der Ansprüche 26 bis 40, mit einem n-seitigen und einem p-seitigen elektrischen Kontaktelement.

**42.** Trägerscheibe mit einer Vielzahl Nitridhalbleiterbauelemente nach einem der Ansprüche 26 bis 41.

**43.** Trägerscheibe nach Anspruch 42, bei dem die Vielzahl Nitridhalbleiterbauelemente auf dem Träger in ihrer Gesamtheit eine laterale Erstreckung von mindestens 24 cm hat.

**44.** Nitridhalbleiterprodukt (100) mit

- einem Substrat (104), das eine Siliziumoberfläche hat,
- einer an die Siliziumoberfläche angrenzenden aluminiumhaltigen Nitridankeimschicht (106),
- optional: einer an die Nitridankeimschicht (106) angrenzenden aluminiumhaltigen Nitridpufferschicht (A),
- einer Maskierungsschicht (108, B) auf der Nitridankeimschicht (106) oder, wenn vorhanden, auf der Nitridpufferschicht (A), wobei
- an die Maskierungsschicht (108, B) angrenzend eine galliumhaltige erste Nitridhalbleiterschicht (110) angeordnet ist, die eine Struktur zusammengewachsener Kristallite aufweist, wobei die Kristallite oberhalb einer Koaleszenzschichtdicke und in einer Schichtebene senkrecht zur Wachstumsrichtung pro Kristallit eine durchschnittliche Fläche von 0,16 $\mu$m$^2$ bis 0,36 $\mu$m$^2$ ein nehmen,
- wobei die Kristallite frühestens ab einem durchschnittlichen Abstand von mindestens 600 nm von der Maskierungsschicht (108, B) zu mehr als 95 % koalesziert sind.

**45.** Nitridhalbleiterprodukt nach Anspruch 44, bei dem die Nitridankeimschicht (106) eine Aluminiumnitridschicht oder eine Aluminiumgalliumnitridschicht mit einem Aluminiumanteil von mindestens 10% ist.

**46.** Nitridhalbleiterprodukt nach Anspruch 45, bei der die Nitridankeimschicht (106) eine Schichtdicke von zwischen 10 und 100 nm hat.

**47.** Nitridhalbleiterprodukt nach einem der Ansprüche 44 bis 46, bei der die Nitridpufferschicht (A) eine Schichtdicke von maximal 400 nm hat.

**48.** Nitridhalbleiterprodukt nach einem der Ansprüche 44 bis 47, bei dem das Substrat (104) in einer zur rückseitigen Substratfläche senkrechten Richtung entweder krümmungsfrei ist oder einem Krümmungsradius von mindestens 10 m hat.

**49.** Nitridhalbleiterprodukt nach einem der Ansprüche 44 bis 48, mit einer aluminiumhaltigen Nitridzwischenschicht (122,F), die an die erste Nitridhalbleiterschicht (110) angrenzt, und,

- angrenzend an letztere Schicht, einer galliumhaltigen weiteren, zweiten Nitridhalbleiterschicht (114).

**50.** Nitridhalbleiterprodukt nach einem der Ansprüche 44 bis 49, bei dem das Substrat (104) eine laterale Erstreckung von mindestens 24 cm hat.

**Claims**

**1.** A process for producing a layer structure (102) of a nitride semiconductor component on a silicon surface, comprising the steps:

- providing a substrate (104) having a silicon surface;
- depositing a nitride seeding layer (106) containing aluminium on the silicon surface of the substrate (104);

- optionally: depositing a nitride buffer layer (A) containing aluminium on the nitride seeding layer;
- depositing a masking layer (108, B) on the nitride seeding layer or on the first nitride buffer layer, if present;
- depositing a first nitride semiconductor layer (110) containing gallium on the masking layer, wherein
- the first nitride semiconductor layer is deposited as a compressively stressed layer on the masking layer,

**characterised in that**

- the masking layer is deposited in such a way that, in the step of depositing the first nitride semiconductor layer (110), separate crystallites initially grow which coalesce above a coalescence layer thickness and occupy an average area of between 0.16 $\mu m^2$ and 0.36 $\mu m^2$ per crystallite in a layer plane perpendicular to the direction of growth of the coalesced nitride semiconductor layer (110),
- and that the masking layer (108, B) is deposited with a layer thickness that permits a layer surface closed by more than 95% to form, on the first nitride semiconductor layer initially growing in the form of separate crystallites, no earlier than with a distance of at least 600 nm on average from the masking layer,
- and that the first nitride semiconductor layer (110) containing gallium is deposited on the masking layer without using coalescence-promoting growth parameters.

2. The process of claim 1, wherein the masking layer (108, B) is deposited with a coverage of at least 95% of the nitride seeding layer (106) thereunder or, if present, of the first nitride buffer layer.

3. The process of any of claims 1 to 2, wherein a masking layer (108, B) of silicon nitride is deposited.

4. The process of any of the preceding claims, wherein the duration of deposition of the masking layer is chosen such that, during the step of depositing the first nitride semiconductor layer (110), concurrent measurement of the reflection intensity of the growth surface at a light wavelength of approximately 600 nm shows oscillating intensity behaviour with an increasing oscillating amplitude that reaches an approximately constant maximum value after at least five oscillation cycles.

5. The process of any one of the preceding claims, wherein the nitride seeding layer (106) is deposited onto a (111) silicon surface.

6. The process of any of the preceding claims, wherein the first nitride semiconductor layer (110) is deposited with a layer thickness of between 800 nm and 1600 nm.

7. The process of claim 6, wherein a nitride intermediate layer (112) containing aluminium is deposited on the first nitride semiconductor layer, and wherein an additional, second nitride semiconductor layer (114) containing gallium is deposited on the former layer.

8. The process of claim 7, wherein the steps of depositing an aluminium-containing nitride intermediate layer (112) and an additional gallium-containing nitride semiconductor layer (114) are performed repeatedly.

9. The process of claim 7 or 8, wherein a multi-quantum well structure (120) of nitride semiconductor material is deposited on the additional nitride semiconductor layer.

10. The process of claim 9, **characterised by** depositing at least one additional masking layer (117) made of silicon nitride immediately before deposition of those additional nitride semiconductor layers on which the multi-quantum well structure (120) is deposited.

11. The process of any one of the preceding claims, wherein n-doping is introduced into the first (110) and, if present, those additional nitride semiconductor layers (114) which are deposited before the multi-quantum well structure (120).

12. The process of any of the preceding claims, comprising the steps: producing a p-doped, gallium-containing nitride semiconductor cover layer (122) on the multi-quantum well structure.

13. The process of any of the preceding claims, wherein the step of providing a substrate includes providing a silicon substrate, the thickness of which is at least $D_{GaN}*x$, where $D_{GaN}$ denotes the layer thickness of the nitride semiconductor layer to be deposited on the substrate or, if more than one nitride semiconductor layer is to be deposited, denotes the sum of the layer thicknesses of the nitride semiconductor layers to be deposited and of the nitride intermediate layer present, and wherein x is equal to 110 in the case where a doped silicon substrate is used and 200 in the case where an undoped substrate is used.

14. A process for producing a nitride semiconductor component, comprising the steps:

- producing a layer structure (102) of a nitride semiconductor component on a silicon surface, in accordance with any of the preceding claims;
- bonding the layer structure (126) to a carrier in such a way that the upper growth surface of the layer structure (102) is facing the carrier;
- either complete or partial removal of the substrate (104);
- producing a contact structure.

15. The process of claim 14, comprising a step of depositing an electrically conductive contact layer on the upper growth surface of the layer structure (102).

16. The process of claim 15, wherein the material used for the contact layer (124, 130) has a higher refractive index than the p-doped nitride semiconductor cover layer.

17. The process of any of claims 14 to 16, comprising a step of metallising the upper growth surface of the layer structure or, if present, of the contact layer, said step being carried out before the bonding step.

18. The process of any of claims 14 to 17, wherein a carried is used whose surface used for bonding is electrically conductive or reflective or metallic.

19. The process of any of claims 16 to 18, wherein the nitride semiconductor cover layer of the layer structure is deposited with a thickness of

$$m \cdot \frac{\lambda}{2 \cdot n_{Nitride}} + \frac{\lambda}{4 \cdot n_{Nitride}} - \frac{d_{MQW}}{2}$$, where m = 0, 1, 2, 3, ..., $\lambda$ is a wavelength of a light emission of the multi-quantum well structure during operation of the nitride semiconductor component, $n_{Nitride}$ is the refractive index of the nitride at wavelength $\lambda$ and $d_{MQW}$ denotes the thickness of the multi-quantum well structure (120).

20. The process of claim 15, wherein the material used for the contact layer (124, 130) has a lower refractive index than the p-doped nitride semiconductor cover layer.

21. The process of claim 20, wherein the nitride semiconductor cover layer of the layer structure is deposited with a thickness of $m \cdot \frac{\lambda}{2 \cdot n_{Nitride}} - \frac{d_{MQW}}{2}$,

where m = 0, 1, 2, 3, 4, ...; $\lambda$ is a wavelength of a light emission of the multi-quantum well structure during operation of the nitride semiconductor component, $n_{Nitride}$ is the refractive index of the nitride at wavelength $\lambda$ and $d_{MQW}$ denotes the thickness of the multi-quantum well structure (120).

22. The process of any of claims 14 to 21, **characterised in that** the bonding step is carried out at a temperature between 280°C and 500°C.

23. The process of any of claims 14 to 22, wherein the step of removing the substrate (104) is carried out by grinding or by a combination of grinding and etching.

24. The process of any of claims 14 to 22, wherein the step of removing the substrate (104) is carried out solely by etching.

25. The process of any of claims 14 to 23, wherein the rear growth side exposed by removal of the substrate is structured to form an anti-reflective layer.

26. A nitride semiconductor component comprising a layer structure (102) containing

- a gallium-containing first nitride semiconductor layer (110) having a structure of coalesced crystallites which occupy an average area of between 0.16 $\mu m^2$ and 0.36 $\mu m^2$ per crystallite in a layer plane perpendicular to the direction of growth,
- an aluminium-containing nitride intermediate layer (112) which adjoins the first nitride semiconductor layer (110), and,
- adjoining the latter layer, an additional, gallium-containing, second nitride semiconductor layer (114), wherein the layer structure is bonded on a carrier in such a way that the second nitride semiconductor layer is disposed facing the carrier and wherein the crystallites of the gallium-containing first nitride semiconductor layer (110) form a layer surface which is closed by more than 95% no earlier than with a distance of 600 nm from that boundary surface of the first nitride semiconductor layer (110) which faces away from the carrier (126).

27. The nitride semiconductor component of claim 26, wherein the crystallites have an average expansion of at least 400 x 400 $nm^2$ in a layer plane perpendicular to the direction of growth.

28. The nitride semiconductor component of claim 26 or 27, wherein the first nitride semiconductor layer (110) has a layer thickness of between 800 nm and 1600 nm.

29. The nitride semiconductor component of any of claims 26 to 28, containing a repeated sequence of aluminium-containing nitride intermediate layer (112) and additional, gallium-containing nitride semiconductor layer (114).

30. The nitride semiconductor component of claim 28 or 29, wherein a multi-quantum well structure (120) of nitride semiconductor material is deposited on the additional nitride semiconductor layer (114).

31. The nitride semiconductor component of claim 30, **characterised by** at least one additional masking layer (117, B) of silicon nitride immediately adjacent that additional nitride semiconductor layer (118) on which the multi-quantum well structure (120) is deposited, but on the side of said additional nitride semiconductor layer (118) that faces away from the multi-quantum well structure (120).

32. The nitride semiconductor component of any of claims 26 to 31, wherein the first (110) and, if present, those additional nitride semiconductor layers (114, 116, 118) are n-doped, that are disposed on the side of the multi-quantum well structure (120) facing the first nitride semiconductor layer (110).

33. The nitride semiconductor component of any of claims 30 to 32, with a p-doped, gallium-containing nitride semiconductor cover layer (122) disposed on the side of the multi-quantum well structure (120) that faces away from the first nitride semiconductor layer (110).

34. The nitride semiconductor component of any of claims 26 to 33, wherein the der carrier (126) and the second nitride semiconductor layer are connected to each other via a metal layer.

35. The nitride semiconductor component of claim 34, wherein the carrier (126) substantially consists of copper or aluminium or silicon or aluminium nitride or of Al/Si.

36. The nitride semiconductor component of any of claims 26 to 35, wherein an electrically conductive contact layer is disposed between the carrier (126) and the second nitride semiconductor layer (114).

37. The nitride semiconductor component of claim 33 and claim 36, wherein the contact layer has a higher refractive index than the p-doped nitride semiconductor cover layer (122).

38. The nitride semiconductor component of claim 33, wherein the nitride semiconductor cover layer of the layer structure is deposited with a thickness of

$$m \cdot \frac{\lambda}{2 \cdot n_{Nitride}} + \frac{\lambda}{4 \cdot n_{Nitride}} - \frac{d_{MQW}}{2} \text{, where } m$$

= 0, 1, 2, 3, ...; $\lambda$ is a wavelength of a light emission of the multi-quantum well structure (120) during operation of the nitride semiconductor components, $n_{Nitride}$ is the refractive index of the nitride at wavelength $\lambda$ and $d_{MQW}$ denotes the thickness of the multi-quantum well structure (120).

39. The nitride semiconductor component of claim 33 and claim 36, wherein the contact layer has a lower refractive index than the p-doped nitride semiconductor cover layer (122).

40. The nitride semiconductor component of claim 39, wherein the nitride semiconductor cover layer of the layer structure has a thickness of

$$m \cdot \frac{\lambda}{2 \cdot n_{Nitride}} - \frac{d_{MQW}}{2} \text{, where } m = 0, 1, 2, 3,$$

4, ...; $\lambda$ is a wavelength of a light emission of the multi-quantum well structure (120) during operation of the nitride semiconductor components, $n_{Nitride}$ is the refractive index of the nitride at wavelength $\lambda$ and $d_{MQW}$ denotes the thickness of the multi-quantum well structure (120).

41. The nitride semiconductor component of any of claims 26 to 40, with one electrical contact element on the n-side and one on the p-side.

42. A carrier wafer comprising a plurality of the nitride semiconductor components of any of claims 26 to 41.

43. The carrier wafer of claim 42, wherein the plurality of nitride semiconductor components has a total lateral extension on the carrier of at least 24 cm.

44. A nitride semiconductor product (100), comprising

- a substrate (104) having a silicon surface,
- an aluminium-containing nitride seeding layer (106) adjoining the silicon surface,
- optionally: an aluminium-containing nitride buffer layer (A) adjoining the nitride seeding layer (106),
- a masking layer (108, B) on the nitride seeding layer (106) or, if present, on the nitride buffer layer (A), wherein
- a gallium-containing first nitride semiconductor layer (110) having a structure of coalesced crystallites is disposed adjoining the masking layer (108, B), wherein the crystallites occupy an average area of between 0.16 $\mu$m$^2$ and 0.36 $\mu$m$^2$ per crystallite above a coalescence layer thickness in a layer plane perpendicular to the direction of growth,
- wherein the crystallites are coalesced by more than 95% no earlier than with an average distance of at least 600 nm from the masking layer (108, B).

**45.** The nitride semiconductor product of claim 44, wherein the nitride seeding layer (106) is an aluminium layer or an aluminium gallium nitride layer with an aluminium content of at least 10%.

**46.** The nitride semiconductor product of claim 45, where the nitride seeding layer (106) has a layer thickness of between 10 and 100 nm.

**47.** The nitride semiconductor product of any of claims 44 to 46, wherein the nitride buffer layer (A) has a layer thickness of at most 400 nm.

**48.** The nitride semiconductor product of any of claims 44 to 47, wherein the substrate (104) is either free of curvature or has a radius of curvature of at least 10 metres in a direction perpendicular to the rear substrate surface.

**49.** The nitride semiconductor product of any of claims 44 to 48, with an aluminium-containing nitride intermediate layer (112, F) which adjoins the first nitride semiconductor layer (110), and,

- adjoining the latter layer, an additional, gallium-containing, second nitride semiconductor layer (114).

**50.** The nitride semiconductor product of any of claims 44 to 49, wherein the substrate (104) has a lateral extension of at least 24 cm.

**Revendications**

**1.** Procédé de production d'une structure (102) stratifiée d'un composant semiconducteur en nitrure sur une surface de silicium, comprenant les stades dans lesquels :

- on se procure un substrat (104), qui a une surface en silicium ;
- on dépose une couche (106) de germe de nitrure sur la surface en silicium du substrat (104) ;
- éventuellement : on dépose une couche (A) tampon de nitrure contenant de l'aluminium sur la couche de germe en nitrure ;
- on dépose une couche (108,B) de masquage sur la couche de germe en nitrure ou, si elle est présente, sur la première couche tampon en nitrure ;
- on dépose une première couche (110) semiconductrice en nitrure contenant du gallium sur la couche de masquage, dans lequel
- on dépose la première couche semiconductrice en nitrure sous la forme d'une couche déformée par compression sur la couche de masquage,

**caractérisé en ce que**

- on dépose la couche de masquage, de manière à ce que, dans le stade de dépôt de la première couche (110) semiconductrice en nitrure, croissent d'abord des cristallites séparés, qui croissent en se réunissant au-delà d'une épaisseur de couche de coalescence et occupent dans un plan de la couche (110) semiconductrice en nitrure ayant crue ensemble, perpendiculairement à la direction de croissance par cristallite, une surface moyenne de 0,16 $\mu m^2$ à 0,36 $\mu m^2$,
- et **en ce que** l'on dépose la couche (108, B) de masquage en une épaisseur de couche qui, pour la première couche semiconductrice en nitrure, croissant d'abord sous la forme des cristallites, permet de créer au plus tôt à partir d'une distance d'en moyenne au moins 600 nm à partir de la couche de masquage, une surface de couche fermée à plus de 95 %,
- et **en ce que** l'on dépose la première couche (110) semiconductrice en nitrure contenant du gallium sur la couche de masquage sans utilisation de paramètre de croissance favorisant une coalescence.

**2.** Procédé suivant la revendication 1, dans lequel on dépose la couche (108,B) de masquage, avec un recouvrement de la couche (106) de germe en nitrure sous-jacente ou, si elle est présente, de la première couche tampon en nitrure d'au moins 95 %.

**3.** Procédé suivant la revendication 1 ou 2, dans lequel on dépose la couche (108, B) de masquage sur du nitrure de silicium.

**4.** Procédé suivant l'une des revendications précédentes, dans lequel on choisit la durée du dépôt de la couche de masquage de manière à ce que, lors du stade de dépôt de la première couche (110) semiconductrice en nitrure, une mesure tournante de l'intensité de la réflexion de la surface de croissance, à une longueur d'onde de la lumière d'environ 600 nm, présente une courbe d'intensité oscillante ayant une amplitude croissante des oscillations, qui atteint une valeur à peu près constante, après au moins 5 cycles d'oscillation.

**5.** Procédé suivant l'une des revendications précédentes, dans lequel on effectue le dépôt de la couche (6) de germe de nitrure sur une surface de silicium (111).

**6.** Procédé suivant l'une des revendications précédentes, dans lequel on dépose la première couche (110) semiconductrice en nitrure en une épaisseur de couche comprise entre 800 nm et 1600 nm.

**7.** Procédé suivant la revendication 6, dans lequel on dépose sur la première couche semiconductrice en nitrure, une couche (112) intermédiaire en nitrure contenant de l'aluminium et dans lequel on dépose sur la dernière couche une deuxième couche (114) semiconductrice en nitrure supplémentaire contenant du gallium.

**8.** Procédé suivant la revendication 7, dans lequel on effectue, de manière répétée, la succession de stades du dépôt d'une couche intermédiaire en nitrure contenant de l'aluminium et d'une couche (114) semiconductrice en nitrure supplémentaire contenant du gallium.

**9.** Procédé suivant la revendication 7 ou 8, dans lequel on dépose, sur la couche semiconductrice supplémentaire en nitrure, une structure (120) à puits-quantique-multiple en un matériau semiconducteur en nitrure.

**10.** Procédé suivant la revendication 9, **caractérisé en ce que** l'on effectue le dépôt d'au moins une autre couche (117) de masquage en nitrure de silicium, juste avant le dépôt de celle des autres couches semiconductrices en nitrure, sur laquelle la structure (120) à puits-quantique-multiple est déposée.

**11.** Procédé suivant l'une des revendications précédentes, dans lequel on introduit un dopage dans la première couche (110) et, si elle est présente, dans celle des autres couches (114) semiconductrices en nitrure, qui sont déposées avant la structure (120) à puits-quantique-multiple.

**12.** Procédé suivant l'une des revendications précédentes, comprenant les stades : de production d'une couche (122) de recouvrement semiconductrice en nitrure à dopage p et contenant du gallium, sur la structure à puits-quantique-multiple.

**13.** Procédé suivant l'une des revendications précédentes, dans lequel le stade, dans lequel on se procure un substrat (104), comporte le fait de se procurer un substrat en silicium, dont l'épaisseur s'élève au moins à $D_{GaN}{}^{*} \alpha$, dans laquelle $D_{GaN}$ est l'épaisseur de la couche semiconductrice en nitrure à déposer sur le substrat ou, s'il y a plus d'une couche semiconductrice à nitrure à déposer, la somme des épaisseurs des couches semiconductrices en nitrure à déposer sur le substrat et de la couche intermédiaire en nitrure présent, et x est égal dans le cas de l'utilisation d'un substrat en silicium dopé, à 110, et dans le cas de l'utilisation d'un substrat non dopé, à 200.

**14.** Procédé de production d'un composé semiconducteur en nitrure comprenant les stades dans lesquels :

    - on produit une structure (102) stratifiée d'un composant semiconducteur en nitrure sur une surface en silicium, suivant l'une des revendications précédentes ;
    - on relie la structure stratifiée à un support (126), de manière à ce que la face supérieure de croissance de la structure (102) stratifiée soit tournée vers le support ;
    - on élimine entièrement ou en partie le substrat (104) ;
    - on produit une structure de contact.

**15.** Procédé suivant la revendication 14, comprenant un stade de dépôt, une couche de contact conductrice de l'électricité sur la face supérieure de croissance de la structure (102) stratifiée.

**16.** Procédé suivant la revendication 15, dans lequel on utilise pour la couche (124, 130) de contact un matériau, qui a un indice de réfraction plus grand que la couche de recouvrement semiconductrice en nitrure à dopage p.

**17.** Procédé suivant l'une des revendications 14 à 16, comprenant un stade, effectué avant la liaison, de métallisation de la face supérieure de croissance de la structure stratifiée ou, si elle est présente, de la couche de contact.

**18.** Procédé suivant l'une des revendications 14 à 17, dans lequel on utilise un support, dont la face utilisée pour la liaison est conductrice de l'électricité ou réfléchissante ou métallique.

**19.** Procédé suivant l'une des revendications 16 à 18, dans lequel on dépose la couche de recouvrement semiconductrice en nitrure de la structure stratifiée en une épaisseur de

$$m \cdot \frac{\lambda}{2 \cdot n_{Nitrid}} + \frac{\lambda}{2 \cdot n_{Nitrid}} - \frac{d_{MQW}}{2} \, ,$$

dans laquelle m = 0, 1, 2, 3, ... ; $\lambda$ est une longueur d'onde d'une émission de lumière de la structure à puits-quantique-multiple en fonctionnement du composant semiconducteur en nitrure, $n_{Nitrid}$ est l'indice de réfraction du nitrure à la longueur d'onde $\lambda$ et $D_{MQW}$ est l'épaisseur de la structure (120) à puits-quantique-multiple.

**20.** Procédé suivant la revendication 15, dans lequel on utilise, pour la couche (124, 130) de contact un matériau, qui a un indice de réfraction plus petit que la couche de recouvrement semiconductrice en nitrure à dopage p.

**21.** Procédé suivant la revendication 20, dans lequel on dépose la couche de recouvrement semiconductrice en nitrure de la structure stratifiée en une épaisseur

de $m \cdot \dfrac{\lambda}{2 \cdot n_{Nitrid}} - \dfrac{d_{MQW}}{2}$ dans laquelle m = 1, 2, 3, 4, ... ; et λ est une longueur d'onde d'une émission de lumière de la structure à puits-quantique-multiple en fonctionnement du composant semiconducteur en nitrure, $n_{Nitrid}$ est l'indice de réfraction du nitrure à la longueur d'onde λ et $D_{MQW}$ est l'épaisseur de la structure (120) à puits-quantique-multiple.

**22.** Procédé suivant l'une des revendications 14 à 21, dans lequel on effectue la liaison à une température comprise entre 280 et 500°C.

**23.** Procédé suivant l'une des revendications 14 à 22, dans lequel on effectue le stade d'élimination du substrat (104) par abrasion ou en combinant une abrasion et une attaque.

**24.** Procédé suivant l'une des revendications 14 à 22, dans lequel on effectue le stade d'élimination du substrat seulement par une attaque.

**25.** Procédé suivant l'une des revendications 14 à 23, dans lequel on structure la face arrière de croissance mise à nu par élimination du substrat, pour la formation d'une couche ayant un effet d'antiréflexion.

**26.** Composant semiconducteur en nitrure ayant une structure (102) stratifiée comprenant

    - une première couche (110) semiconductrice en nitrure contenant du gallium, qui a une structure de cristallites rassemblés par croissance, qui occupe dans un plan de couche perpendiculairement à la direction de croissance, par cristallite, une surface moyenne comprise entre 0,16 $\mu m^2$ et 0,36 $\mu m^2$,
    - une couche (112) intermédiaire en nitrure contenant de l'aluminium, qui est voisine de la première couche (110) semiconductrice en nitrure, et
    - voisine de la dernière couche, une deuxième couche (114) semiconductrice en nitrure supplémentaire contenant du gallium, la structure stratifiée étant liée sur un support, de manière à ce que la deuxième couche semiconductrice en nitrure soit tournée vers le support et dans lequel les cristallites de la première couche (110) semiconductrice en nitrure contenant du gallium forment, au plus tôt, à partir d'une distance de 600 nm de la surface limite de la première couche (110) semiconductrice en nitrure qui est éloignée du support (126), une surface de couche fermée à plus de 95 %.

**27.** Composant semiconducteur en nitrure suivant la revendication 26, dans lequel les cristallites ont, dans un plan de couche perpendiculaire à la direction de croissance, une étendue moyenne d'au moins 400 x 400 $nm^2$.

**28.** Composant semiconducteur en nitrure suivant l'une des revendications 26 ou 27, dans lequel la première couche (110) semiconductrice en nitrure a une épaisseur comprise entre 800 nm et 1600 nm.

**29.** Composant semiconducteur en nitrure suivant l'une des revendications 26 à 28, qui contient de manière répétée la succession de couches constituée de la couche (112) intermédiaire en nitrure contenant de l'aluminium et de la couche (114) semiconductrice en nitrure supplémentaire contenant du gallium.

**30.** Composant semiconducteur en nitrure suivant l'une des revendications 28 ou 29, dans lequel une structure (120) à puits-quantique-multiple en matériau semiconducteur en nitrure est déposée sur la couche (114) semiconductrice supplémentaire en nitrure.

**31.** Composant semiconducteur en nitrure suivant la revendication 30, **caractérisé par** au moins une couche (117, B) de masquage supplémentaire en nitrure de silicium, directement voisine de celle des autres couches (118) semiconductrices en nitrure, sur laquelle la structure (120) à puits-quantique-multiple est déposée, mais du côté de cette autre couche (118) semiconductrice en nitrure qui est éloignée de la structure (120) à puits-quantique-multiple.

**32.** Composant semiconducteur en nitrure suivant l'une des revendications 26 à 31, dans lequel la première couche (110) et, lorsqu'elles sont présentes, les autres couches (114, 116, 118) semiconductrices en nitrure, sont à dopage n, en étant disposées du côté de la structure (120) à puits-quantique-multiple, qui est tourné vers la première couche (110) semiconductrice en nitrure.

**33.** Composant semiconducteur en nitrure suivant l'une des revendications 30 à 32, comprenant une couche (122) de recouvrement semiconductrice en nitrure à dopage p et contenant du gallium, qui est disposée du côté de la structure (120) à puits quantique multiple éloigné de la première couche (110) semiconductrice en nitrure.

**34.** Composant semiconducteur en nitrure suivant l'une des revendications 26 à 33, dans lequel le support (126) et la deuxième couche semiconductrice en nitrure sont reliés entre eux par une couche métallique.

**35.** Composant semiconducteur en nitrure suivant la revendication 34, dans lequel le support (126) est constitué essentiellement de cuivre ou d'aluminium ou de silicium ou de nitrure d'aluminium ou d'Al/Si.

**36.** Composant semiconducteur en nitrure suivant l'une des revendications 26 à 35, dans lequel une couche de contact conductrice de l'électricité est interposée entre le support (126) et la deuxième couche (114) semiconductrice en nitrure.

**37.** Composant semiconducteur en nitrure suivant la revendication 33 et la revendication 36, dans lequel la couche de contact a un indice de réfraction plus grand que la couche (122) de recouvrement semiconductrice en nitrure à dopage p.

**38.** Composant semiconducteur en nitrure suivant la revendication 33, dans lequel la couche de recouvrement en nitrure de la structure stratifiée est déposée en une épaisseur de

$$m \cdot \frac{\lambda}{2 \cdot n_{Nitrid}} + \frac{\lambda}{2 \cdot n_{Nitrid}} - \frac{d_{MQW}}{2} \, ,$$

dans laquelle m = 0, 1, 2, 3, ... ; $\lambda$ est une longueur d'onde d'une émission de lumière de la structure à puits- quantique- multiple en fonctionnement du composant semiconducteur en nitrure, $n_{Nitrid}$ est l'indice de réfraction du nitrure à la longueur d'onde $\lambda$ et $D_{MQW}$ est l'épaisseur de la structure (120) à puits- quantique- multiple.

**39.** Composant semiconducteur en nitrure suivant la revendication 33 et la revendication 36, dans lequel la couche de contact a un indice de réfraction plus petit que la couche (122) de recouvrement semiconductrice en nitrure à dopage p.

**40.** Composant semiconducteur en nitrure suivant la revendication 39, dans lequel la couche de recouvrement semiconductrice en nitrure de la structure stratifiée a une épaisseur de

$$m \cdot \frac{\lambda}{2 \cdot n_{Nitrid}} - \frac{d_{MQW}}{2} \, , \text{ dans laquelle}$$

m = 1, 2, 3, 4, ... ; et $\lambda$ est une longueur d'onde d'une émission de lumière de la structure à puits-quantique-multiple en fonctionnement du composant semiconducteur en nitrure, $n_{Nitrid}$ est l'indice de réfraction du nitrure à la longueur d'onde $\lambda$ et $D_{MQW}$ est l'épaisseur de la structure (120) à puits-quantique-multiple.

**41.** Composant semiconducteur en nitrure suivant l'une des revendications 26 à 40, comprenant un élément de contact électrique du côté n et un élément de contact électrique du côté p.

**42.** Tranche formant support et ayant une pluralité de composants semiconducteurs en nitrure suivant l'une des revendications 26 à 41.

**43.** Tranche formant support suivant la revendication 22, dans lequel la pluralité de composants semiconducteurs en nitrure sur le support a, dans son ensemble, une étendue latérale d'au moins 24 cm.

**44.** Produit (100) semiconducteur en nitrure, comprenant

- un substrat (104), qui a une surface en silicium,
- une couche (106) de germe en nitrure contenant de l'aluminium et voisine de la surface de silicium,
- éventuellement : une couche (A) tampon en nitrure contenant de l'aluminium et voisine de la couche (106) de germes en nitrure,
- une couche (108, B) de masquage sur la couche (106) de germe en nitrure ou, si elle est présente, sur la couche (A) tampon en nitrure, dans lequel
- au voisinage de la couche (108, B) de masquage est disposée une première couche (110) semiconductrice en nitrure contenant du gallium, qui comporte une structure de cristallites ayant cru ensemble, les cristallites occupant, au-delà d'une épaisseur de couche de coalescence et dans un plan de couche perpendiculaire à la direction de croissance, par cristallite, une surface moyenne de 0,16 $\mu m^2$ à 0, 36 $\mu m^2$,
- dans lequel les cristallites sont coalescée à plus de 95 % au plus tôt, à partir d'une distance moyenne d'au moins 600 nm de la couche (108, B) de masquage.

**45.** Produit semiconducteur en nitrure suivant la revendication 44, dans lequel la couche (106) de germe en nitrure est une couche de nitrure d'aluminium ou une couche de nitrure d'aluminium et de gallium ayant une proportion d'aluminium d'au moins 10 %.

**46.** Produit semiconducteur en nitrure suivant la revendication 45, dans lequel la couche (106) de germe en nitrure a une épaisseur comprise entre 10 et 100 nm.

**47.** Produit semiconducteur en nitrure suivant l'une des revendications 44 et 46, dans lequel la couche (A) tampon en nitrure a une épaisseur au maximum de 400 nm.

**48.** Produit semiconducteur en nitrure suivant l'une des revendications 44 à 47, dans lequel le substrat (104) n'a pas de courbure dans une direction perpendiculaire à la face arrière du substrat ou a un rayon de courbure d'au moins 10 m.

**49.** Produit semiconducteur en nitrure suivant l'une des revendications 44 à 48, comprenant une couche (112, F) intermédiaire en nitrure contenant de l'aluminium, qui est voisine de la première couche (110) semiconductrice en nitrure, et,

- au voisinage de la dernière couche, une autre deuxième couche (114) semiconductrice en nitrure contenant du gallium.

**50.** Produit semiconducteur en nitrure suivant l'une des revendications 44 à 49, dans lequel le substrat (10) a une étendue latérale d'au moins 24 cm.

EP 1 875 523 B1

FIG. 1

FIG. 2

FIG. 3

FIG. 4a
STAND DER TECHNIK

FIG. 4b

FIG. 4c

FIG. 5a

STAND DER TECHNIK

FIG. 5b

FIG. 6a  FIG. 6b

EP 1 875 523 B1

FIG. 6c

FIG. 6d

FIG. 6e

FIG. 6f

EP 1 875 523 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10151092 A1

- DE 102004038573 A1

**In der Beschreibung aufgeführte Nicht-Patentliteratur**

- **A. Dadgar et al.** Reduction of Stress at the Initial Stages of GaN Growth on Si(111). *Applied Physics Letters,* 2003, vol. 82 (1), 28-30
- **C. Mo et al.** Growth and characterization of InGaN blue LED structure on Si(111) by MOCVD. *Journal of Crystal Growth,* 2005, vol. 285, 312-317

- **A. Krost et al.** *phys. stat. sol. (b),* 2005, vol. 242, 2570-2574
- **A. Krost et al.** *phys. stat. sol. (a),* 2003, vol. 200, 26-35